Europäisches Patentamt

European Patent Office

Office européen des brevets

(19)

(11) **EP 1 434 240 A1**

(12) **EUROPÄISCHE PATENTANMELDUNG**

(43) Veröffentlichungstag:
**30.06.2004 Patentblatt 2004/27**

(51) Int Cl.$^7$: **G21K 1/06**

(21) Anmeldenummer: **04003479.5**

(22) Anmeldetag: **27.03.1999**

(84) Benannte Vertragsstaaten:
**DE FR GB IE IT NL**

(30) Priorität: **05.05.1998 DE 19819898**
**02.02.1999 DE 19903807**
**08.02.1999 DE 29902108 U**

(62) Dokumentnummer(n) der früheren Anmeldung(en)
nach Art. 76 EPÜ:
**99106348.8 / 0 955 641**

(71) Anmelder:
• **Carl Zeiss**
**89518 Heidenheim (Brenz) (DE)**
Benannte Vertragsstaaten:
**DE FR IT NL**
• **Carl-Zeiss-Stiftung, trading as Carl Zeiss**
**89518 Heidenheim (Brenz) (DE)**
Benannte Vertragsstaaten:
**GB IE**

(72) Erfinder: **Die Erfindernennung liegt noch nicht vor**

(74) Vertreter: **Dr. Weitzel & Partner**
**Friedenstrasse 10**
**89522 Heidenheim (DE)**

Bemerkungen:
Diese Anmeldung ist am 17 - 02 - 2004 als
Teilanmeldung zu der unter INID-Kode 62
erwähnten Anmeldung eingereicht worden.

(54) **Beleuchtungssystem insbesondere für die EUV-Lithographie**

(57) Die Erfindung betrifft ein Beleuchtungssystem für Wellenlängen ≤ 193 nm, insbesondere für die EUV-Lithographie, mit

- wenigstens einer Lichtquelle (1),
- wenigstens einem ersten Spiegel oder einer Linse, der bzw. die in erste Rasterelemente gegliedert ist;
- ein oder mehrere optische Elemente, die zwischen dem wenigstens einen Spiegel oder der einen Linse, der bzw. die in erste Rasterelemente (5) gegliedert ist und einer Retikelebene (14, 316, 406) angeordnet (ist) sind dadurch gekennzeichnet, dass

- die ersten Rasterelemente (5) des bzw. der Spiegel oder Linse (n) ein auf den Spiegel bzw. Linse einfallendes Strahlbüschel in eine Vielzahl von Teilbüscheln aufspaltet und unter einem ersten Ablenkwinkel ablenkt, wobei der erste Ablenkwinkel von wenigstens zwei Teilbüscheln verschieden ist.

FIG. 1

## Beschreibung

Die Erfindung betrifft ein Beleuchtungssytem gemäß dem Oberbegriff des Anspruches 1 sowie eine Projektionsbelichtungsanlage mit einem derartigen Beleuchtungssystem.

Um die Strukturbreiten für elektronische Bauteile noch weiter reduzieren zu können, insbesondere in dem Submikron-Bereich, ist es erforderlich, die Wellenlänge des für die Mikrolithographie eingesetzten Lichtes zu verringern. Denkbar ist bei Wellenlängen kleiner als 193 nm beispielsweise die Lithographie mit weichen Röntgenstrahlen, sog. EUV-Lithographie.

Ein für die EUV-Lithographie geeignetes Beleuchtungssystem soll mit möglichst wenigen Reflektionen das für die EUV-Lithographie vorgegebene Feld, insbesondere das Ringfeld eines Objektivs homogen, d.h. uniform ausleuchten, des weiteren soll die Pupille des Objektives feldunabhängig bis zu einem bestimmten Füllgrad σ ausgeleuchtet werden und die Austrittspupille des Beleuchtungssystems in der Eintrittspupille des Objektivs liegen.

Aus der US 5,339,346 ist ein Beleuchtungssystem für eine Lithographieeinrichtung, die EUV-Strahlen verwendet, bekanntgeworden. Zur gleichmäßigen Beleuchtung in der Retikelebene und Füllung der Pupille schlägt die US 5,339,346 einen Kondensor vor, der als Kollektorlinse aufgebaut ist und wenigstens vier paarweise Spiegelfacetten, die symmetrisch angeordnet sind, umfaßt. Als Lichtquelle wird eine Plasma-Lichtquelle verwendet.

In der US 5,737,137 ist ein Beleuchtungssystem mit einer Plasma-Lichtquelle umfassend einen Kondensorspiegel, gezeigt, bei dem mit Hilfe von sphärischen Spiegeln eine Ausleuchtung einer zu beleuchtenden Maske bzw. eines Retikels erzielt wird.

Die US 5,361,292 zeigt ein Beleuchtungssystem, bei dem eine Plasma-Lichtquelle vorgesehen ist und die punktförmige Plasma-Lichtquelle mit Hilfe eines Kondensors, der fünf asphärische, außermittig angeordnete Spiegel aufweist, in eine ringförmig ausgeleuchtete Fläche abgebildet wird. Mit Hilfe einer speziellen nachgeordneten Abfolge von grazing-incidence-Spiegeln wird die ringförmig ausgeleuchtete Fläche dann in die Eintrittspupille abgebildet.

Aus der US 5,581,605 ist ein Beleuchtungssystem bekanntgeworden, bei dem ein Photonenstrahler mit Hilfe eines Wabenkondensors in eine Vielzahl von sekundären Lichtquellen aufgespalten wird. Hierdurch wird eine gleichmäßige bzw. uniforme Ausleuchtung in der Retikelebene erreicht. Die Abbildung des Retikels auf den zu belichtenden Wafer erfolgt mit Hilfe einer herkömmlichen Reduktionsoptik. Im Beleuchtungsstrahlengang ist genau ein gerasterter Spiegel mit gleich gekrümmten Elementen vorgesehen.

Aufgabe der Erfindung ist es, ein möglichst einfach aufgebautes Beleuchtungssystem und ein Verfahren zum Design eines solchen anzugeben, mit dem die Anforderungen an ein Belichtungssystem für Wellenlängen ≤ 193 nm, insbesondere im EUV-Bereich erfüllt werden können und als Lichtquelle beliebige Lichtquellen mit beliebiger Ausleuchtung in einer vorbestimmten Fläche A zum Einsatz gelangen sollen. Insbesondere sollen neben einer uniformen Ausleuchtung des Retikels auch die Telezentrieanforderungen eines System für Wellenlängen ≤ 193 nm erfüllt werden.

Unter Telezentrie wird in der vorliegenden Anmeldung verstanden, daß das Gesamtsystem am Wafer telezentrisch ist. Dies erfordert eine Anpassung der Austrittspupille des Beleuchtungssystems an die Eintrittspupille des Objektives, die für ein reflektives Retikel im Endlichen liegen.

In der vorliegenden Anmeldung ist die Telezentrieanforderung dann erfüllt, wenn die Abweichung der Schwerstrahlen von Beleuchtung und Objektiv in der Retikelebene ein bestimmtes Maß, beispielsweise ± 4,0 mrad, vorzugsweise ± 1,0 mrad nicht überschreitet und die Schwerstrahlen telezentrisch auf den Wafer treffen.

Erfindungsgemäß wird die Aufgabe dadurch gelöst, daß bei dem oberbegrifflichen Beleuchtungssystem die Rasterelemente der Spiegel- oder Linsenvorrichtung auf dem Spiegel oder der Linse derart geformt und angeordnet sind, daß die Bilder der Rasterelemente durch die optischen Elemente zum überwiegenden Teil in der Retikelebene zur Deckung kommen, und daß die durch Apertur und Füllgrad definierte Austrittspupille des Beleuchtungssystems, die die Eintrittspupille der Reduktionsoptik ist, weitgehend gleichmäßig beleuchtet wird. Dabei kann die Eintrittspupille auch nach der Feldhöhe variieren, z.B. axial versetzt sein.

Während das System bei Wellenlängen im EUV-Bereich rein reflektiv, d.h. ausschließlich mit Spiegelkomponenten designt ist, gelangen bei 193 nm bzw. 157 nm-System refraktive Komponenten wie Linsen zum Einsatz.

Die Erfindung stellt somit auch im 193 nm bzw. 157 nm-Bereich ein Beleuchtungssystem bzw. ein Konstruktionsprinzip zur Verfügung, das mit möglichst wenig optischen Elementen, wie beispielsweise Linsen oder Prismen auskommt. Dies ist bei 193 nm bzw. 157 nm deswegen wichtig, weil die optischen Elemente hohe Absorptionen aufweisen.

Des weiteren stellt die Erfindung ein Verfahren zum Design eines Beleuchtungssystems für Wellenlängen ≤ 193 nm, insbesondere für die EUV-Lithographie zur Verfügung.

Das Verfahren zum Design eines Beleuchtungssystems umfassend eine Lichtquelle mit beliebiger Ausleuchtung A in einer vorbestimmten Fläche, einer Spiegel- oder Linsenvorrichtung umfassend wenigstens zwei Spiegel oder Linsen, die in Rasterelemente gegliedert sind, sowie optischen Elementen, die zwischen der Spiegel- oder Linsenvorrichtung und der Retikelebene angeordnet sind, umfaßt erfindungsgemäß die nachfolgenden Schritte:

- die Rasterelemente des ersten Spiegels oder Linse werden derart angeordnet, daß das Feld abgedeckt wird und weisen eine Form auf, die der des auszuleuchtenden Feldes entspricht, wobei jedem Rasterelement eine sekundäre Lichtquelle zugeordnet ist;
- die Rasterelemente des zweiten Spiegels oder der Linse werden derart angeordnet, daß sie am Ort der sekundären Lichtquelle sitzen und weisen eine Form auf, die der der sekundären Lichtquellen entsprechen;
- durch Drehen und Kippen der einzelnen Rasterelemente der Spiegel oder durch Orientierung und Wahl des Ablenkwinkels des prismatischen Anteils der Linse(n) wird ein Lichtweg zwischen den Spiegeln oder Linsen hergestellt, wobei eine vorbestimmte Zuordnung der Rasterelemente des ersten Spiegels oder der ersten Linse zu den Rasterelementen des zweiten Spiegels oder der zweiten Linse eingehalten wird; so daß
- eine Überlagerung der Bilder in der Retikelebene erreicht wird und
- durch die optischen Elemente die sekundären Lichtquellen in die Austrittspupille abgebildet werden.

Mit dem erfindungsgemäßen Beleuchtungssystem und dem erfindungsgemäßen Verfahren wird das Feld in der Retikelebene homogen und mit partiell gefüllter Apertur ausgeleuchtet. Durch Einbringen einer Feldlinse in ein derartiges Beleuchtungssystem wird die Austrittspupille des Beleuchtungssystems mit der Eintrittspupille des Objektivs zusammengelegt.

Bevorzugt handelt es sich bei den Projektionssystemen um Ringfeldsysteme, so daß das auszuleuchtende Feld in der Retikelebene ein Ringsegment darstellt.

Zur Formung des Ringfeldes, zur Erzeugung von Lichtleitwert und zur Homogenisierung der Feldverteilung ist in einer speziellen Form der Erfindung einer oder mehrere der Spiegel mit Rasterelementen ähnlich einem Wabenkondensor ausbildet.

Ein Wabenkondensor mit planer Trägerfläche ist aus der US 5,581,605, deren Offenbarungsgehalt insbesondere auch im Hinblick auf die Herstellung solcher Kondensoren vollumfänglich in die Offenbarung dieser Anmeldung aufgenommen wird, dargestellt.

Besonders bevorzugt sind die Waben des Wabenkondensors in ihrer Geometrie ähnlich der des auszuleuchtenden Feldes, d.h. bei einem Ringfeldsystem mit Aspektverhältnis 1:V können die Waben als Rechtecke mit einem Aspektverhältnis 1:V ausgestaltet sein.

Um auch bei unsymmetrisch oder von der Punktform abweichenden Lichtquellen eine uniforme Ausleuchtung des Retikels zu erhalten und den Telezentrieanforderungen - wie zuvor definiert - zu genügen, ist mit Vorteil ein zweiter Spiegel oder Linse mit Rasterelementen vorgesehen.

Die Rasterelemente des ersten Spiegels oder die Waben der Linse sollen nachfolgend als Feldwaben, die Rasterelemente des zweiten Spiegels oder die Waben der zweiten Linse als Pupillenwaben bezeichnet werden.

Um die zuvor angesprochene beliebige Ausleuchtung (kreisförmig, rechteckig, zusammengesetzte Verteilungen) in der Fläche A aufzunehmen und andererseits die Pupille gleichmäßig auszuleuchten, ist es von Vorteil, wenn die Waben über die Freiheitsgrade Position und Kipp in bezug auf die Spiegeloberfläche verfügen. Bei Linsensystemen können diese Freiheitssignale anstelle von Kipp und Position der einzelnen Waben bzw. Rasterelemente durch Orientierung, Ablenk- bzw. Keilwinkel und Position der Prismen vor den einzelnen Waben realisiert werden. Gemäß der Erfindung sind die Feldwaben so anzuordnen, daß die ausgeleuchtete Eingangsebene optimal abgedeckt wird. Die Position der Pupillenwaben wird dadurch bestimmt, daß man die in der Eintrittspupille des Objektivs vorgegebenen sekundären Lichtquellen entgegen der Lichtrichtung durch die Feldlinse in die Blendenebene des Beleuchtungssystems abbildet.

Nachdem die Anordnung der Einzelwaben auf den jeweiligen Spiegeln oder Linsen aufgrund obiger Randbedingungen festgelegt wurde, ist beispielsweise durch Verkippen von Feld- und Pupillenwaben bei Spiegelsystemen oder prismatischen Anteilen an den Waben eine Verbindung der Lichtkanäle herzustellen. Besonders bevorzugt ist es, wenn die Zuordnung von Feld- und Pupillenwaben derart gewählt wird, daß die Kippwinkel bzw. der prismatische Anteil minimiert sind. Alternativ kann eine Zuordnung angestrebt werden, bei der die Intensitätsverteilung in der Pupille weitgehend homogen ist.

Um den aufgrund des gefalteten Strahlenganges verbleibenden Tilt in der Pupillenausteuchtung zu korrigieren, kann vorgesehen sind, die Reflektivität auf dem bzw. den Spiegel(n) einzustellen.

Nachfolgend sollen die bevorzugten Weiterbildungen der Erfindung anhand von Spiegelsystemen beispielhaft beschrieben werden, ohne daß hierin eine Beschränkung auf reflektive Systeme zu sehen ist. Der Fachmann wird die beispielhaft genannten Maßnahmen ohne erfinderisches Zutun auf refraktive Systeme übertragen, ohne daß dies explizit erwähnt wird.

Generell wird bei den erfindungsgemäßen Systemen die Uniformität der Feldausleuchtung und die Verteilung der sekundären Lichtquellen, die wiederum für den Füllgrad σ verantwortlich ist, durch die Anzahl und Anordnung der Waben des ersten Spiegels, also des Wabenkonsensors, gegeben. Die Form des ausgeleuchteten Feldes ist durch die Form der einzelnen Waben auf der ersten Wabenplatte gegeben. Liegt ein hohes Aspektverhältnis der Einzelwaben vor, so kann durch zeilenweises Verschieben der Waben eine gleichmäßige Verteilung der sekundären Lichtquellen erreicht werden.

Bei Systemen mit zwei Spiegeln mit Rasterelementen ist die Form der Waben des zweiten Spiegels an die Form der sekundären Lichquellen angepaßt und somit verschieden von der Form der ersten Waben. Besonders bevorzugt sind diese Waben rund, wenn auch die Lichtquelle rund ausgebildet ist.

Die den Spiegeln mit Rasterelementen, insbesondere Waben, nachgeordneten optischen Elemente dienen dazu, die zweite Wabenplatte, d.h. die Pupillenebene, in die Eintrittspupille des Projetionsobjektives abzubilden, das Ringfeld zu formen und die Beleuchtungsverteilung entsprechend den Anforderungen des Belichtungsprozesses zu erzeugen.

Besonders bevorzugt ist es, wenn die optischen Elemente grazing-incidence-Spiegel mit Inzidenzwinkel $\leq$ 15° umfassen. Um die mit jeder Reflektion verbundenen Lichtverluste zu minimieren, ist mit Vorteil vorgesehen, wenn die Anzahl der Feldspiegel gering gehalten wird. Besonders bevorzugt sind Ausführungsformen mit höchstens zwei Feldspiegeln.

Nachfolgend soll ein Zahlenbeispiel gegeben werden, aus dem die für die EUV-Lithographie typischen Werte zu ersehen sind.

Fordert man eine Apertur in der Waferebene $NA_{Wafer}$ = 0.1-0.15, so bedeutet dies bei 4:1 Systemen eine Apertur in der Retikelebene von $NA_{Retikel}$ = 0.025-0.375. Soll das Beleuchtungssystem diese Apertur bis zu einem Füllgrad von $\sigma$ = 0.6 homogen und feldunabhängig ausleuchten, so muß die EUV-Quelle über folgenden 2-dim-Lichtleitwert (LLW):

$$LLW_{Bel.} = \sigma\ LLW_{obj} = 0.236\ mm^2$$

verfügen. Der Lichtleitwert LLW ist wie folgt allgemein definiert:

$$LLW = x{\cdot}y{\cdot}NA^2 = A \cdot NA^2$$

Um für die Lichtquelle, insbesondere die EUV-Quelle diesen Lichtleitwert zu realisieren, muß diese entsprechend angepaßt sein.

Bei zu großem Lichtleitwert der Quelle wird an geeigneter Stelle durch Vignettierung der Lichtleitwert auf das geforderte Maß reduziert. Bei zu kleinem Lichtleitwert der Quelle kann der Lichtleitwert effektiv erhöht werden. Möglich ist der Einsatz von Streuscheiben oder eine partiell gefüllte Pupille, wie sie durch Segmentierung in der Erfindung vorgeschlagen wird.

Als Lichtquelle für das erfindungsgemäße EUV-Beleuchtungssystem kann in einer ersten Ausführungsform eine Laser-Plasma-Quelle vorgesehen sein.

Die Laser-Plasma-Quelle weist folgende Parameter auf:

- Durchmesser 50μm-200μm
- Abstrahlwinkelbereich: $4\ \pi$

Da die Abstrahlung einer Laser-Plasma-Quelle kugelförmig ist, wird zur Aufnahme der abgestrahlten Lichtleistung vorteilhafterweise ein Ellipsoidspiegel verwendet, der das Licht der Kugelquelle in ein konvergentes Strahlbüschel umformt.

Bei ausgedehnten Laser-Plasma-Quellen, beispielsweise mit einem Durchmesser von 200 μm, ist es zur Vermeidung von Verschmierungen und zur korrekten Überlagerung der Strahlenbüschel der Feldwaben vorteilhaft, einen zweiten Spiegel mit Rasterelementen vorzusehen. Bei einem punktförmigen Strahler beispielsweise mit einem Durchmesser von 50 μm sind die Verschmierungen so gering, daß auf eine solche Maßnahme verzichtet werden kann.

Eine andere Lichtquelle für das erfindungsgemäße Beleuchtungssystem ist eine Pinch-Plasma-Quelle.

Eine Pinch-Plasma-Quelle läßt sich als Flächenstrahler (∅ = 1.00 mm) beschreiben, der in das Raumwinkelelement $\Omega$ = 0,3 sr abstrahlt. Zur korrekten Überlagerung der einzelnen Wabenbilder ist, wie bei den ausgedehnten Laser-Plasma-Quellen, eine Wabenplatte am Ort der sekundären Lichtquellen erforderlich. Ein erfindungsgemäßes System mit einer Pinch-Plasma-Quelle umfaßt bevorzugt wenigstens die nachfolgenden Elemente: einen Kollektorspiegel, einen Planfacettenspiegel bzw. ersten Wabenkondensor zur Erzeugung der sekundären Lichtquellen und zur Feldformung und einen Pupillenfacettenspiegel bzw. zweiten Wabenkondensor zur korrekten Feldüberlagerung sowie nachfolgende optische Elemente, beispielsweise zwei Feldspiegel. Die Waben des ersten Wabenkondensors sind in einer ersten Ausführungsform plan ausgebildet und einzeln-gekippt, wohingegen die Waben des zweiten Wabenkondensors sphärisch gekrümmt sind und regulär ohne Kipp auf dem Spiegel angeordnet sind. Zur Vermeidung von Vignettierungen ist das Gesamtsystem vorteilhafterweise im Zick-Zack-Strahlengang angeordnet.

Um insbesondere bei Systemen mit Laser-Plasma-Quellen eine kurze Baulänge realisieren zu können, ist in einer besonderen Ausgestaltung der Erfindung ein Tele-System vorgesehen. Dieses Tele-System kann mit dem Wabenkondensor gekoppelt werden, so daß keine weiteren Spiegel erforderlich sind. Das Tele-System hat den weiteren Vorteil, daß die sekundären Lichtquellen auf der zweiten Wabenplatte dichter gepackt angeordnet sind.

Die Telewirkung kann beispielsweise dadurch erzeugt werden, daß die Waben auf einer gekrümmten Trägerfläche angebracht sind, oder daß jeder Wabe ein prismatischer Anteil, der bei Linsensystemen beispielsweise durch den Waben vorgeordnete Prismen, bei Spiegelsystemen durch Kipp der Waben, realisiert wird.

Selbstverständlich sind neben den zuvor beispielhaft beschriebenen speziellen EUV-Lichtquellen, wie Laser-Plasma, Plasma oder Pinch-Plasma-Quelle auch noch andere EUV-Lichtquellen denkbar, ohne daß von der Erfindung abgewichen wird.

Besonders bevorzugte weitere EUV-Lichtquellen sind Synchrotronstrahlungsquellen. Synchronstrahlung wird emittiert, wenn relativitische Elektronen in einem Magnetfeld abgelenkt werden. Die Synchrotron-Strahlung wird tangential zur Elektronenbahn emittiert.

Bei Synchrotronstrahlungsquellen unterscheidet man derzeit drei Arten von Quellen:

- Bending-Magneten
- Wiggler
- Undulatoren

Bei Bending-Magnet-Quellen werden die Elektronen durch einen Bending-Magneten abgelenkt und Photonen-Strahlung emittiert.

Wiggler-Quellen umfassen zur Ablenkung des Elektrons bzw. eines Elektronenstrahles einen sogenannten Wiggler, der eine Vielzahl von aneinandergereihten abwechselnd gepolten Magnetpaaren umfaßt. Durchläuft ein Elektron einen Wiggler, so wird das Elektron einem periodischen, vertikalen Magnetfeld ausgesetzt; das Elektron oszilliert dementsprechend in der horizontalen Ebene. Wiggler zeichnen sich weiter dadurch aus, daß keine Kohärenzeffekte auftreten. Die mittels eines Wigglers erzeugte Synchrotronstrahlung ähnelt der eines Bending-Magneten und strahlt in einen horizontalen Raumwinkel ab. Sie weist im Gegensatz zum Bending-Magneten einen um die Anzahl der Pole des Wigglers verstärkten Fluß auf.

Der Übergang von Wiggler-Quellen zu Undulator-Quellen ist fließend.

Bei Undulator-Quellen werden die Elektronen im Undulator einem Magnetfeld mit kürzerer Periode und geringerem Magnetfeld der Ablenkpole als beim Wiggler ausgesetzt, so daß Interferenz-Effekte der Synchrotronstrahlung auftreten. Die Synchrotronstrahlung weist aufgrund der Interferenzeffekte ein diskontinuierliches Spektrum auf und strahlt sowohl horizontal wie vertikal in ein kleines Raumwinkelelement ab; d.h. die Strahlung ist stark gerichtet.

Sämtliche zuvor beschriebenen Synchrotron-EUV-Strahlungsquellen stellen bei geeigneter Dimensionierung EUV-Strahlung beispielsweise von 13 bzw. 11 nm mit ausreichender Leistung für die EUV-Lithographie zur Verfügung.

Betreffend Synchrotron-Strahlung wird auf Emst Eckhart Koch, "Handbook of Synchrotron Radiation", 1983, Elsevier-Science, New York, verwiesen, wobei der Offenbarungsgehalt dieser Schrift in die vorliegende Anmeldung vollumfänglich mitaufgenommen wird.

Nachfolgend soll die Erfindung anhand der Zeichnungen beschrieben werden.

Es zeigen:

| | |
|---|---|
| Fig. 1: | Prinzipskizze des Strahlengangs eines Systems mit zwei Wabenplatten; |
| Fig. 2a, 2b: | Feld- und Pupillen-Abbildung für das zentrale Wabenpaar; |
| Fig. 3: | Verlauf der Lichtstrahlen für eine Rechteckfeldwabe in Kombination mit einer Rechteckpupillenwabe; |
| Fig. 4: | Verlauf gemäß Fig. 3 mit in den Strahlverlauf eingebrachter Feldlinse; |
| Fig. 5: | Verlauf gemäß Fig. 3 mit zwei in den Strahlverlauf eingebrachten Feldlinsen; |
| Fig. 6: | System mit Feld- und Pupillenwaben; |
| Fig.7-14: | unterschiedliche Anordnungen von Feldwaben auf einer Feldwabenplatte; |
| Fig. 15-17: | Gitter von sekundären Lichtquellen in der Eintrittspupille des Objektives; |
| Fig. 18-20: | Zusammenhang zwischen ausgeleuchteten Flächen von Pupillenwabenplatte und Feldwabenplatte sowie Baulänge und Apertur in der Retikelebene; |
| Fig. 21-22: | Beleuchtungssystem mit einer Kollektoreinheit, einem zerstreuenden sowie einem sammelnden Spiegel; |
| Fig. 23-24: | Strahlverlauf in einem System mit Kollektoreinheit, zerstreuendem und sammelndem Spiegel; |
| Fig. 25-26: | Ausleuchtung des Retikels eines Systems gemäß Fig. 23-24; |
| Fig. 27-28: | Ausleuchtung des Retikels mit einem Rechteckfeld eines Systems gemäß Fig. 23-24 ohne Pupillenwaben; |
| Fig. 29: | Vergleich des Intensitätsverlaufes eines Systems gemäß Fig. 23-24 mit und ohne Pupillenwaben- |

| | | |
|---|---|---|
| | | platte; |
| Fig. 30: | | integrale Scan-Energie in der Retikelebene eines Systems gemäß Fig. 23-24 mit Pupillenwabenplatte; |
| Fig. 31: | | Pupillenausleuchtung des Projektionsobjektives eines Systems gemäß Fig. 23-24 mit Pupillenwabenplatte; |
| Fig. 32: | | Gesamtenergie der Teilpupillen eines Systems gemäß Fig. 23-24 entlang der Y-Achse; |
| Fig. 33-39: | | erfindungsgemäßes System mit einer Laserplasmaquelle als Lichtquelle sowie einer Kollektoreinheit und zwei Spiegeleinheiten, die ein Tele-System ausbilden; |
| Fig. 40-45: | | Verlauf der Lichtstrahlen in einem System mit Kollektoreinheit sowie zwei Telespiegeln gemäß Fig: 33-39; |
| Fig. 46: | | Ausleuchtung des Retikelfeldes einer Anordnung gemäß Fig. 44-45; |
| Fig. 47: | | integrale Scan-Energie einer Anordnung gemäß Fig. 40-45; |
| Fig. 48: | | Pupillenausleuchtung eines Systems gemäß Fig. 40-45; |
| Fig. 48A-48C: | | System für eine Laser-Plasma-Quelle mit Durchmesser $\leq 50$ μm und nur einer Wabenplatte; |
| Fig. 49-52: | | System mit einer Laser-Plasma-Quelle, einem Kollektor und einer Feldwabenplatte mit planen Waben; |
| Fig. 53-58: | | Strahlverläufe in einem System gemäß Fig. 49-52; |
| Fig. 59: | | Ausleuchtung des Retikels mit einer Beleuchtungsanordnung gemäß Fig. 52-58; |
| Fig. 60: | | integrale Scan-Energie in der Retikelebene eines Systems gemäß Fig. 52-58; |
| Fig. 61: | | Pupillenausleuchtung eines Systems gemäß Fig. 52-58; |
| Fig. 62: | | Intensitätsverlauf in Scanrichtung eines Systems gemäß Fig. 52-58; |
| Fig. 63A: | | Wabenkondensor mit einzelnen Feldwaben auf einer gekrümmten Trägerfläche; |
| Fig. 63B: | | Wabenkondensor mit gekippten Waben auf einer ebenen Trägerplatte; |
| Fig. 64: | | eine Ausgestaltung der Erfindung mit Linsen und davor angeordneten Prismen in schematischer Darstellung. |

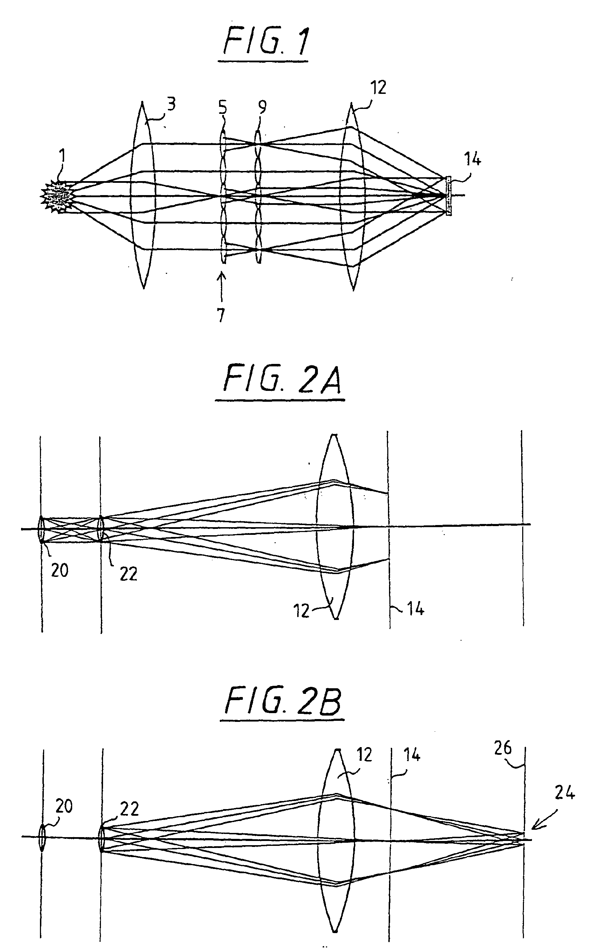

Anhand der Fig. 1-20 soll theoretisch dargestellt werden, wie mit Hilfe des erfindungsgemäßen Designverfahrens bzw. der erfindungsgemäßen Beleuchtungseinrichtung für beliebige Beleuchtungsverteilungen A in einer Ebene ein System angegeben werden kann, das den Anforderungen in bezug auf Uniformität und Telezentrie genügt.

In Figur 1 ist eine Prinzipskizze des Strahlengangs eines Systemes mit zwei Wabenplatten abgebildet. Das Licht der Quelle 1 wird mit Hilfe einer Kollektorlinse 3 gesammelt und in ein paralleles oder konvergentes Lichtbüschel umgewandelt. Die Feldwaben 5 der ersten Wabenplatte 7 zerlegen die Lichtbüschel und erzeugen am Ort der Pupillenwaben 9 sekundäre Lichtquellen. Die Feldlinse 12 bildet diese sekundären Lichtquellen in die Austrittspupille des Beleuchtungssystems bzw. die Eintrittspupille des nachfolgenden Objektives ab. Eine derartige Anordnung zeichnet sich durch einen verflochtenen Strahlengang von Feld- und Pupillenebene von der Quelle bis zur Eintrittspupille des Objektivs aus. Hierfür wird oft auch die Bezeichnung "Köhlersche Beleuchtung" gewählt.

Nachfolgend wird das Beleuchtungssystem gemäß Fig. 1 abschnittsweise betrachtet. Da die Schnittstelle die Licht- und Aperturverteilung in der Ebene der Feldwaben ist, kann die Betrachtung unabhängig von der Quellenart und dem Kollektorspiegel erfolgen.

In Fig. 2A und 2B ist für das zentrale Wabenpaar 20, 22 die Feld- und Pupillen-Abbildung eingezeichnet. Mit Hilfe der Pupillenwabe 22 und der Feldlinse 12 wird die Feldwabe 20 auf das Retikel 14 bzw. die abzubildende Maske abgebildet. Die geometrische Ausdehnung der Feldwabe 20 bestimmt die Form des ausgeleuchteten Feldes in der Retikelebene 14. Der Abbildungsmaßstab ist näherungsweise durch das Verhältnis der Abstände Pupillenwabe 22 - Retikel 14 und Feldwabe 20 - Pupillenwabe 22 gegeben. Die optische Wirkung der Feldwabe 20 ist so ausgelegt, daß am Ort der Pupillenwabe 22 ein Bild der Lichtquelle 1 entsteht, eine sekundäre Lichtquelle. Ist die Ausdehnung der Lichtquelle gering, beispielsweise näherungsweise punktförmig, so verlaufen alle Lichtstrahlen durch die optische Achse der Pupillenwabe 22. In einem solchen Fall ist eine Beleuchtungseinrichtung realisierbar, bei der auf die Pupillenwabe verzichtet wird.

Wie in Fig. 2 B gezeigt, besteht die Aufgabe der Feldlinse 12 darin, die sekundären Lichtquellen in die Eintrittspupille 26 des Objektivs 24 abzubilden. Bringt man in den Strahlengang eine Feldlinse ein, so wird die Feldabbildung in der Weise beeinflußt, daß sie das Ringfeld durch Steuerung der Verzeichnung formt. Der Abbildungsmaßstab der Feldwabenabbildung wird dadurch nicht verändert.

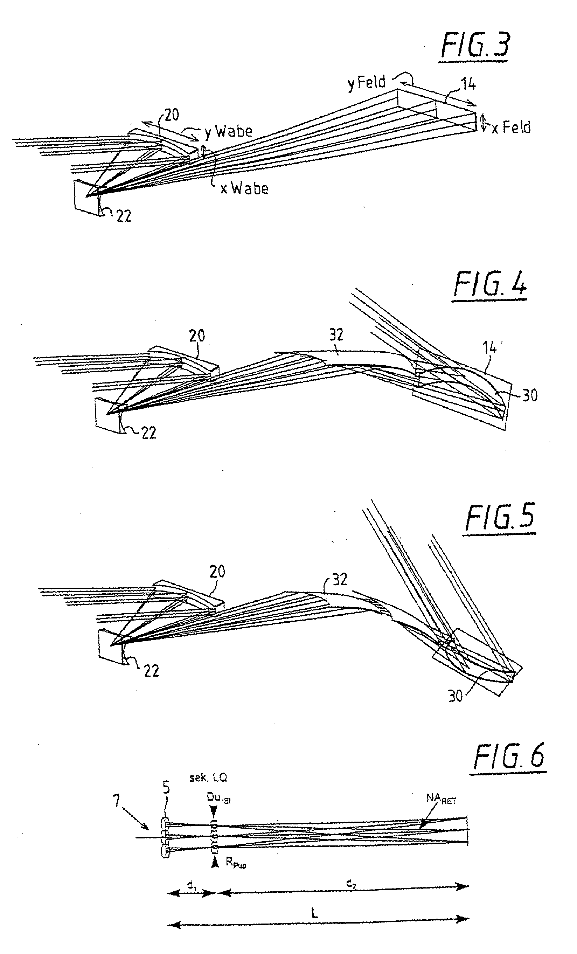

In Figur 3 ist für eine spezielle geometrische Form einer Feldwabe und einer Pupillenwabe der Verlauf der Lichtstrahlen dargestellt.

In der in Figur 3 dargestellten Ausführungsform ist die Form der Feldwaben 20 rechteckig gewählt. Dabei entspricht das Aspektverhältnis der Feldwaben 20 dem Verhältnis von Bogenlänge zu Ringbreite des geforderten Ringfeldes in der Retikelebene. Das Ringfeld wird, wie in Fig. 4 dargestellt, durch die Feldlinse geformt. Ohne Feldlinse ergibt sich, wie in Fig. 3 gezeigt, in der Retikelebene ein Rechteckfeld.

Zur Formung des Ringfeldes 30 wird, wie in Fig. 4 dargestellt, eine grazingincidence-Feldspiegel 32 verwandt. Unter der Nebenbedingung, daß die vom Retikel reflektierte Strahlung nicht mehr ins Beleuchtungssystem zurücklaufen darf, sind je nach Lage der Eintrittspupille des Objektivs ein oder zwei Feldspiegel 32 erforderlich.

Laufen die Hauptstrahlen divergent ins nicht dargestellte Objektiv, so genügt ein Feldspiegel 32, wie in Figur 4 dargestellt. Bei konvergentem Hauptstrahlverlauf benötigt man zwei Feldspiegel. Der zweite Feldspiegel muß die Orientierung des Ringes umdrehen. Eine derartige Konfiguration ist in Figur 5 gezeigt.

Bei einem Beleuchtungssystem im EUV-Wellenlängenbereich müssen alle Komponenten reflektiv ausgebildet werden.

Wegen der hohen Reflektionsverluste bei $\lambda$ = 10 nm - 14 nm ist es vorteilhaft, daß die Zahl der Reflektionen so gering wie möglich gehalten werden.

Beim Aufbau des reflektiven Systems muß die gegenseitige Vignettierung der Strahlen berücksichtigt werden. Dies kann durch Aufbau des Systemes im Zick-Zack-Strahlengang erfolgen oder durch Arbeiten mit Obskurationen.

Nachfolgend soll das erfindungsgemäße Verfahren zum Erstellen eines Designs für ein EUV-Beleuchtungssystem bei beliebiger Ausleuchtung in einer Ebene A beispielhaft beschrieben werden.

Die für das erfindungsgemäße Verfahren erforderlichen Definitionen sind in Fig. 6 gezeigt.

Zunächst wird der Strahlengang für das zentrale Wabenpaar berechnet.

In einem ersten Schritt wird die Größe der Feldwaben 5 der Feldwabenplatte 7 bestimmt werden. Wie zuvor aufgezeigt, ergibt sich für Rechteckwaben das Aspektverhältnis (x/y) aus der Form des Ringfeldes in der Retikelebene. Die Größe der Feldwaben wird bestimmt durch die Ausdehnung A der Intensitätsverteilung der beliebigen Lichtquelle in der Ebene der Feldwaben und der Anzahl N der Feldwaben auf der Wabenplatte, die wiederum durch die Zahl der sekundären Lichtquellen gegeben ist. Die Anzahl der sekundären Lichtquellen ergibt sich wiederum aus der Gleichmäßigkeit der Pupillenausleuchtung sowie der Durchmischung.

Die Wabenfläche $A_{Wabe}$ einer Feldwabe mit $x_{Wabe}$, $y_{Wabe}$ kann wie folgt ausgedrückt werden:

$$A_{Wabe} = x_{Wabe} \cdot y_{Wabe} = (x_{Feld} / y_{Feld}) \cdot y_{Wabe}^2$$

wobei $x_{Feld}$, $y_{Feld}$ die Größe des Rechteckes, das das Ringfeld festlegt, beschreibt. Weiter gilt für die Anzahl N der Feldwaben:

$$N = \frac{A}{A_{Wabe}} = \frac{A}{y_{Wabe}^2 \cdot (x_{Feld} / y_{Feld})}$$

Hieraus folgt für die Größe der einzelnen Feldwabe:

$$y_{Wabe} = \sqrt{\frac{A}{N \cdot (x_{Feld}/y_{Feld})}}$$

und

$$x_{Wabe} = (x_{Feld} / y_{Feld}) \cdot y_{Wabe}$$

Die Wabengröße und die Größe des Rechteckfeldes legen den Abbildungsmaßstab $\beta_{Wabe}$ der Wabenabbildung fest und damit das Verhältnis der Abstände $d_1$ und $d_2$.

$$\beta_{Wabe} = \frac{x_{Feld}}{y_{Feld}} = \frac{d_2}{d_1}$$

Die vorgegebene Baulänge L für das Beleuchtungssystem und der Wabenabbildungsmaßstab $\beta_{Wabe}$ bestimmen die absolute Größe von $d_1$ und $d_2$ und damit die Lage der Pupillenwabenplatte. Es gilt:

$$d_1 = \frac{L}{1 + \beta_{Wabe}}$$

$$d_2 = d_1 \cdot \beta_{Wabe}$$

$d_1$ und $d_2$ bestimmen wiederum den Radius der Pupillenwaben.

Es gilt:

$$R_{Pup} = \frac{2 \cdot d_1 \cdot d_2}{d_1 + d_2}$$

Um die Pupillenwaben in die Eintrittspupille des Objektives abzubilden und das Rechteckfeld in ein Ringfeld umzuformen, werden zwischen Pupillenwabe und Retikel eine oder mehrere Feldlinsen, vorzugsweise in Toroidform, eingebracht. Durch die Einführung der Feldspiegel wird die vorgegebene Baulänge vergrößert, da unter anderem die Spiegel Mindestabstände einhalten müssen, um Vignettierungen zu vermeiden.

Die Positionierung der Feldwaben hängt von der Intensitätsverteilung in der Ebene der Feldwaben ab. Die Zahl N der Feldwaben ist durch die Zahl der sekundären Lichtquellen vorgegeben. Die Feldwaben werden vorzugsweise derart auf der Feldwabenplatte angeordnet, daß sie die ausgeleuchtete Fläche, ohne sich gegenseitig zu vignettieren, abdecken.

Zur Positionierung der Pupillenwaben wird in der Eintrittspupille des Objektivs die Rasterung der sekundären Lichtquellen vorgegeben. Die sekundären Lichtquellen werden entgegen der Lichtrichtung durch die Feldlinse abgebildet. Die Blendenebene dieser Abbildung befindet sich in der Retikelebene. Die Bilder der sekundären Lichtquellen geben die (x, y, z)-Position der Pupillenwaben an. Als Freiheitsgrad für die Herstellung des Lichtweges zwischen Feld- und Pupillenwabe verbleibt der Kipp- und Drehwinkel.

Wird in einer Ausgestaltung der Erfindung jeder Feldwabe eine Pupillenwabe zugeordnet, so wird der Lichtweg durch Kippung und Drehung von Feld- und Pupillenwabe hergestellt. Hierbei werden die Strahlbüschel so umgelenkt, daß die Mittenstrahlen alle in der Retikelebene die optische Achse schneiden.

Die Zuordnung von Feld- und Pupillenwaben ist frei. Eine Möglichkeit der Zuordnung wäre, jeweils räumlich benachbarte Waben einander zuzuordnen. Dadurch werden die Umlenkwinkel minimal. Eine andere Möglichkeit besteht darin, die Intensitätsverteilung in der Pupillenebene auszugleichen. Dies kommt beispielsweise dann zum Tragen, wenn die Intensitätsverteilung in der Ebene der Feldwaben einen Verlauf aufweist. Haben Feld- und Pupillenwaben ähnliche Positionen, überträgt sich der Verlauf auf die Pupillenausleuchtung.

Durch gezielte Durchmischung der Zuordnung kann die Intensität ausgeglichen werden.

Vorteilhafterweise werden die Einzelkomponenten Feldwabenplatte, Pupillenwabenplatte und Feldspiegel des Beleuchtungssystems im Strahlengang derart angeordnet, daß ein vignettierungsfreier Strahlenverlauf möglich ist. Hat eine derartige Anordnung Auswirkungen auf die Abbildung, so müssen die einzelnen Lichtkanäle und die Feldlinse nachoptimiert werden.

Mit dem zuvor beschriebenen Design-Verfahren können für beliebige Ausleuchtungen A mit zwei normal-incidence und ein bis zwei grazingincidence-Reflektionen Beleuchtungssysteme für die EUV-Lithographie erhalten werden, die folgende Eigenschaften aufweisen:

- eine homogene Ausleuchtung beispielsweise eines Ringfeldes
- eine homogene und feldunabhängige Pupillenausleuchtung
- das Zusammenlegen von Austrittspupille des Beleuchtungssystems und Eintrittspupille des Objektivs
- das Einstellen einer vorgegebenen Baulänge
- die Aufnahme des maximal möglichen Lichtleitwertes.

Nachfolgend sollen für eine Ausführungsform der Erfindung mit Feld- und Pupillenwabenplatte Anordnungen von Feldwaben und Pupillenwaben beschrieben werden.

Zunächst werden unterschiedliche Anordnungen der Feldwaben auf der Feldwabenplatte betrachtet. Hierbei kann die Intensitätsverteilung beliebig sein.

Die angeführten Beispiele beschränken sich auf einfache geometrische Formen, wie Kreis, Rechteck, die Kopplung mehrerer Kreise bzw Rechtecke.

Innerhalb des ausgeleuchteten Bereichs soll die Intensitätverteilung homogen sein oder einen langsam variierenden Verlauf aufweisen. Die Aperturverteilung soll unabhängig vom Feld sein.

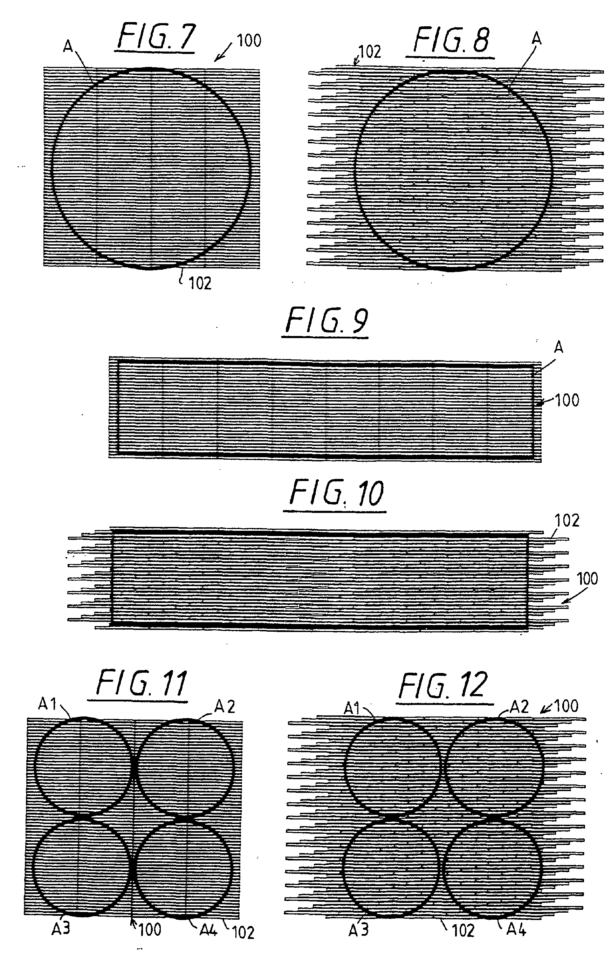

Bei kreisförmiger Ausleuchtung A der Feldwabenplatte 100 können die Feldwaben 102 zum Beispiel in Spalten und Zeilen angeordnet sein, wie in Figur 7 dargestellt. Alternativ hierzu können die Aufpunkte der Waben gleichmäßig durch Verschieben der Zeilen über die Fläche verteilt sein, wie in Figur 8 dargestellt. Letztere Anordnung ist besser an eine gleichmäßige Verteilung der sekundären Lichtquellen angepaßt.

Eine rechteckige Ausleuchtung A ist in Figur 9 dargestellt. Eine Verschiebung der Zeilen, wie in Figur 10 dargestellt, führt zu einer gleichmäßigeren Verteilung der sekundären Lichtquellen. Diese sind jedoch entsprechend der Ausdehnung der Feldwabenplatte innerhalb eines Rechtecks angeordnet. Bei rechteckiger Ausleuchtung ist es erforderlich, zur Herstellung des Lichtweges zwischen Feld- und Pupillenwaben die Feldwaben so zu kippen, daß die Strahlbüschel auf die beispielsweise innerhalb eines Kreises angeordneten Pupillenwaben treffen, die ebenfalls gekippt werden müssen.

Setzt man die Ausleuchtung A der Feldwabenplatte 100 aus mehreren Kreisen A1, A2, A3, A4 zusammen, beispielsweise durch Kopplung von mehreren Quellen, so ist bei gleichbleibender Wabengröße die Durchmischung bei einer Anordnung der Waben in Zeilen und Spalten gemäß Figur 11 unzureichend. Eine gleichmäßigere Beleuchtung erhält man durch die Verschiebung der Wabenzeilen, wie in Figur 12 dargestellt.

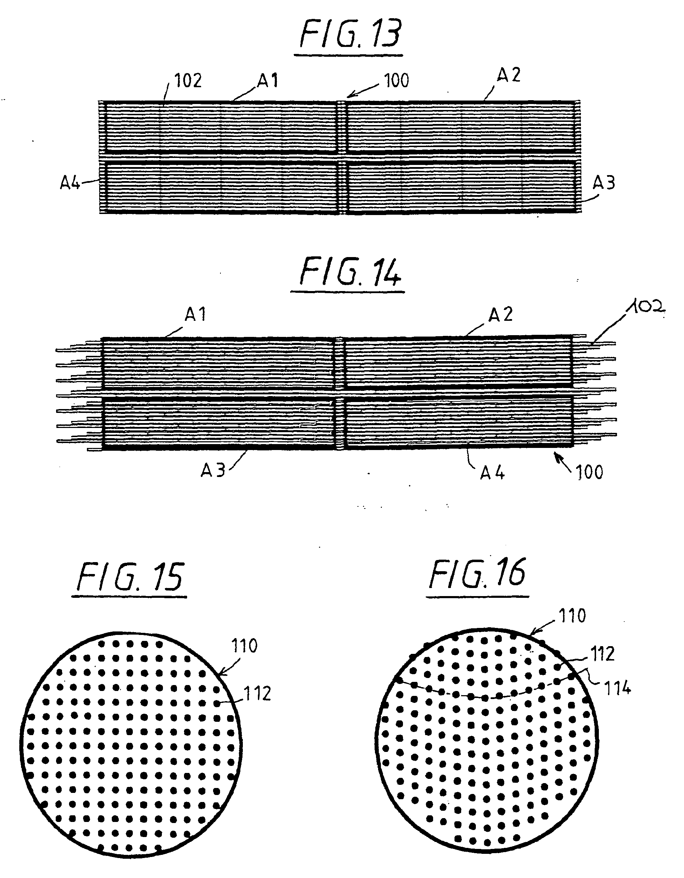

Die Figuren 13 und 14 zeigen die Verteilung der Feldwaben 102 bei zusammengesetzter Ausleuchtung aus Einzelrechtecken A1, A2, A3, A4.

Nunmehr sollen beispielhafte Anordnungen der Pupillenwaben auf der Pupillenwabenplatte beschrieben werden.

Bei der Anordnung der Pupillenwaben sind zwei Gesichtspunkte zu berücksichtigen:

1. Für die Minimierung der Kippwinkel von Feld- und Pupillenwaben zur Herstellung des Lichtweges ist es vorteilhaft, sich an die Anordnung der Feldwaben zu halten. Dies ist insbesondere bei näherungsweise kreisförmiger Ausleuchtung der Feldwabenplatte vorteilhaft.

2. Zur homogenen Pupillenfüllung sollen die sekundären Lichtquellen in der Eintrittspupille des Objektivs gleichmäßig verteilt sein. Dies kann erreicht werden, indem man in der Eintrittspupille des Objektivs eine gleichmäßige Rasterung von sekundären Lichtquellen vorgibt. Diese werden entgegen der Lichtrichtung mit der Feldlinse in die Ebene der Pupillenwaben abgebildet und bestimmen dadurch den idealen Ort der Pupillenwaben.

Ist die Feldlinse verzeichnungsfrei, so entspricht die Verteilung der Pupillenwaben der Verteilung der sekundären Lichtquellen. Da die Feldlinse jedoch das Ringfeld formt, wird gezielt Verzeichnung eingeführt. Dabei handelt es sich nicht um rotationssymmetrische kissen- oder tonnenförmige Verzeichnung, sondern um die Verbiegung von horizontalen Linien zu Bögen. Der y-Abstand der Bögen bleibt im Idealfall konstant. Reale grazing-incidence-Feldspiegel zeigen jedoch auch eine zusätzliche Verzeichnung in y-Richtung.

In Figur 15 ist ein Gitter 110 von sekundären Lichtquellen 112 in der Eintrittspupille des Objektivs, die zugleich Austrittspupille des Beleuchtungssystems ist, gezeigt, wie es sich für verzeichnungsfreie Abbildung ergeben würde. Die Anordnung der sekundären Lichtquellen 112 entspricht genau der vorgegebenen Anordnung der Pupillenwaben.

Werden wie in Figur 16 die Feldlinsen zur Ringfeldformung eingesetzt, so liegen die sekundären Lichtquellen 112 auf Bögen 114.

Legt man die Pupillenwaben einzelner Zeilen auf Bögen, die die Verzeichnung vorhalten, so kann man die sekundären Lichtquellen wieder auf ein regelmäßiges Gitter legen.

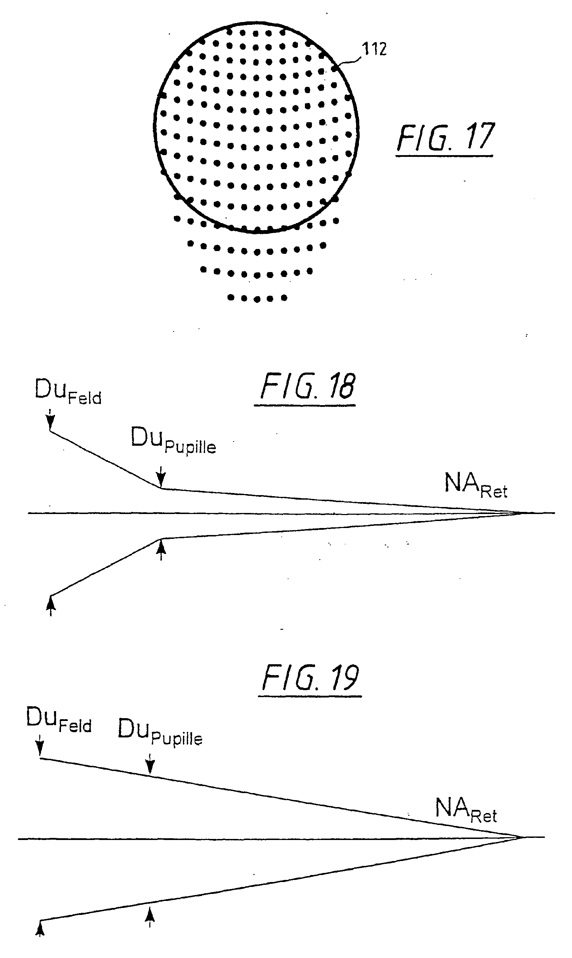

Führt die Feldlinse zusätzlich Verzeichnung in y-Richtung ein, so wird die Pupille in y-Richtung verzerrt, wie in Figur 17 gezeigt.

Die Ausdehnung der ausgeleuchteten Fläche auf der Feldwabenplatte ist mit der Definition der Eingangsbeleuchtung vorgegeben. Die Ausleuchtung der Pupillenwabenplatte ist durch die Baulänge und die Apertur in der Retikelebene bestimmt.

Wie zuvor eingehend beschrieben, müssen durch Dreh und Kipp von Feldund Pupillenwaben die beiden Flächen aufeinander abgestimmt werden.

Zur Veranschaulichung wird die Problematik an refraktiven Aufbauten erläutert. Die Beispiele lassen sich jedoch direkt auf reflektive Systeme übertragen. Für eine kreisförmige Ausleuchtung der Feldwabenplatte sind verschiedene Fälle zu unterscheiden, wie nachfolgend dargestellt.

Wird durch Kipp der Feldwaben eine sammelnde Wirkung, durch Kipp der Pupillenwaben eine zerstreuende Wirkung eingeführt, so kann der Büschelquerschnitt verringert werden. Die Kippwinkel der einzelnen Waben werden mit Hilfe der Mittenstrahlen für jedes Wabenpaar bestimmt. Für die Mittenstrahlen wirkt das System wie ein Tele-System, wie in Figur 18 gezeigt.

Inwieweit die Feldwaben gekippt werden müssen, hängt von der Konvergenz des eintreffenden Strahlbüschels ab. Ist die Konvergenz an die Verringerung des Büschelquerschnitts angepaßt, können die Feldwaben ohne Kippwinkel auf einem Plansubstrat angebracht werden.

Ein Spezialfall ergibt sich, wenn die Konvergenz zwischen Feld- und Pupillenwabenplatte der Apertur am Retikel entspricht, wie in Figur 19 gezeigt.

Muß keine zerstreuende Wirkung durch die Pupillenwaben eingeführt werden, so können sie ohne Flächenkipp eingesetzt werden. Wenn zudem die Lichtquelle einen sehr kleinen Lichtleitwert besitzt, kann auf die Pupillenwaben vollständig verzichtet werden.

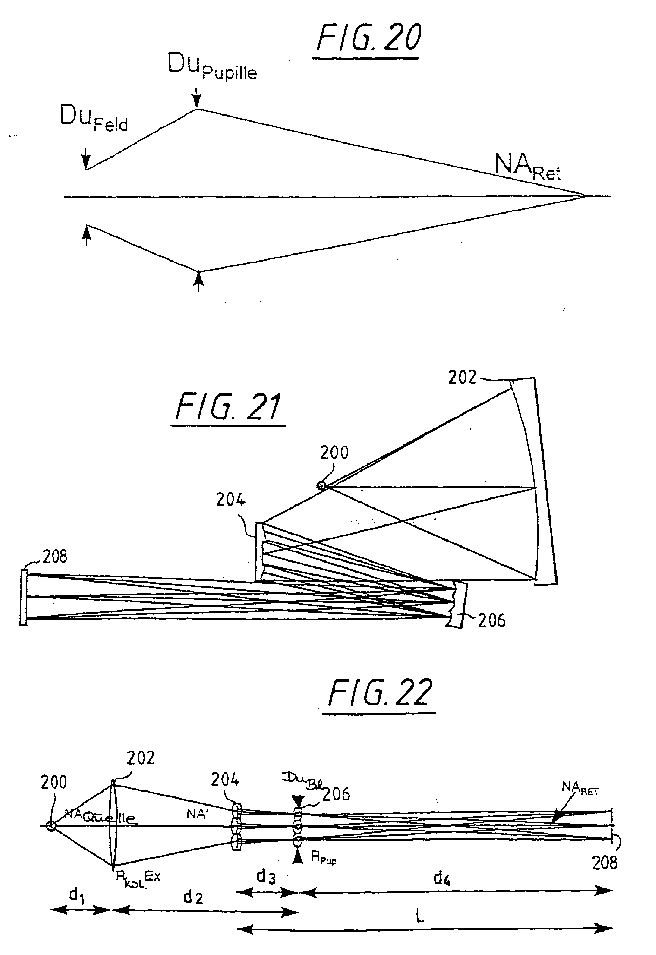

Eine Vergrößerung des Büschelquerschnitts ist möglich, wenn durch Kipp der Feldwaben zerstreuende Wirkung, durch Kipp der Pupillenwaben sammelnde Wirkung eingeführt wird. Für die Mittenstrahlen wirkt das System wie ein Retrofokus-System, wie in Figur 20 gezeigt.

Entspricht die Divergenz der eintreffenden Strahlung der Büschelvergrößerung zwischen Feld- und Pupillenwaben, so können die Feldwaben ohne Flächenkipp verwendet werden.

Anstelle der beschriebenen runden Form sind auch rechteckige oder andere Formen der Ausleuchtung A der Feldwabenplatten möglich.

Die nachfolgenden Zeichnungen beschreiben eine Ausführungsform der Erfindung, bei der als Lichtquelle des EUV-Beleuchtungssystems eine Pinch-Plasma-Quelle verwendet wird.

In Figur 21 ist der prinzipielle Aufbau ohne Feldlinse einer derartigen Ausführungsform gezeigt; Figur 22 zeigt die für die Systemableitung notwendigen Abkürzungen, wobei zur besseren Darstellung das System linear aufgezogen und die Spiegel als Linsen angedeutet wurden. Ein Beleuchtungssystem mit Pinch-Plasma-Quelle 200, wie in Fig. 21 dargestellt, umfaßt eine Lichtquelle 200, einen Kollektorspiegel 202, der das Licht sammelt und in die Feldwabenplatte 204 reflektiert. Durch Reflexion an den Feldwaben wird das Licht zu den jeweiligen Pupillenwaben der Pupillenwabenplatte 206 geführt und von dort zum Retikel 208. Die Pinch-Plasma-Quelle ist eine ausgedehnte Lichtquelle (ca. 1 mm) mit einer gerichteten Strahlung in einen relativ kleinen Raumwinkelbereich von ungefähr $\Omega$ = 0,3 sr. Aufgrund ihrer Ausdehnung ist bei Beleuchtung mit einer Pinch-Plasma-Quelle ein Pupillenwabenkondensor 206 empfehlenswert.

Nachfolgende Größenvorgaben sind beispielhaft für ein Beleuchtungssystem für die EUV-Lithographie:

- Ringfeld: R = 100 mm, Segment = 60°, Feldhöhe ± 3.0 mm, was einem Rechteckfeld von 105 mm x 6 mm entspricht
- Apertur am Retikel: $NA_{Ret}$ = 0.025
- Apertur an der Quelle: $NA_{Quelle}$ = 0.3053
- Baulänge L = 1400.0 mm
- Anzahl der Waben, die in einer x-Zeile Platz finden: 4
- $d_1$ = 330.0 mm

Beachtet man die nachfolgende Verknüpfung der einzelnen Größen:

$$NA_{Ret} = \frac{DU_{BL}/2}{L} \qquad\qquad \Rightarrow DU_{BL} = 2 \cdot L \cdot NA_{Ret}$$

$$\frac{DU_{BL}}{x_{Wabe}} = 4.0 \qquad \Rightarrow x_{Wabe} = \frac{DU_{BL}}{4.0}$$

$$\beta_{Wabe} = \frac{x_{Feld}}{x_{Wabe}} = \frac{d_4}{d_3} \qquad\qquad \Rightarrow \beta_{Wabe} = \frac{x_{Feld}}{x_{Wabe}}$$

$$\Rightarrow d_4 = d_3 \cdot \beta_{Wabe}$$

$$L = d_3 + d_4 \qquad \Rightarrow d_3 = \frac{L}{1 + \beta_{Wabe}}$$

$$NA' = \frac{DU_{BL}/2}{d_3} \qquad\qquad \Rightarrow NA' = \frac{DU_{BL}/2}{d_3}$$

$$\tan(\theta) = -\frac{|1\text{-}Ex|\cdot\sin|\theta'|}{2\sqrt{E}x - |1-Ex|\cdot\cos|\theta'|} \qquad \Rightarrow Ex = f(NA_{QU}, NA')$$

$$Ex = \left(\frac{sk-s1}{sk+s1}\right)^2 = \left(\frac{d_2-d_1}{d_2+d_1}\right)^2 \qquad\qquad \Rightarrow d2 = d1\cdot\frac{1+\sqrt{Ex}}{1-\sqrt{Ex}}$$

$$Ex = 1 - \frac{R_{Kol}}{a} \qquad \Rightarrow R_{Kol} = \frac{d_1+d_2}{2}\cdot(1-Ex)$$

$$\frac{2}{R_{Pup}} = \frac{1}{d_3} + \frac{1}{d_4} \qquad \Rightarrow R_{Pup} = \frac{2\cdot d_3 \cdot d_4}{d_3+d_4}$$

so läßt sich aus den vorgegebenen Größen das System komplett bestimmen.

Setzt man die Vorgaben für Ringfeld, Apertur am Retikel etc. in die obigen Formeln ein, so ergeben sich nachfolgende Systemparameter:

$$DU_{BL} = 2\cdot L\cdot NA_{Ret} = 2\cdot 1400\ mm\cdot 0.025 = 70.0\ mm$$

$$x_{Wabe} = \frac{DU_{BL}}{4.0} = \frac{70.0\ mm}{4.0} = 17{,}5\ mm$$

$$\beta_{Wabe} = \frac{x_{Feld}}{x_{Wabe}} = \frac{105.0\ mm}{17.5\ mm} = 6.0$$

$$d_3 = \frac{L}{1+\beta_{Wabe}} = \frac{1400.0\ mm}{1+6.0} = 200.0\ mm$$

$$d_4 = d_3\cdot\beta_{Wabe} = 200.0\ mm\cdot 6.0 = 1200.0\ mm$$

$$NA' = \frac{DU_{BL}/2}{d_3} = \frac{70.0\ mm/2}{200.0\ mm} = 0.175$$

$$Ex = f(NA_{QU}, NA') = 0.078$$

$$d_2 = d_1\cdot\frac{1+\sqrt{Ex}}{1-\sqrt{Ex}} = 330.0\ mm\cdot\frac{1+\sqrt{0.078}}{1-\sqrt{0.078}} = 585.757\ mm$$

$$R_{Kol} = \frac{d_1+d_2}{2}\cdot(1-Ex) = \frac{330.0\ mm + 585.757\ mm}{2}\cdot(1-0.078) = 422.164\ mm$$

$$R_{Pup} = \frac{2 \cdot d_3 \cdot d_4}{d_3 + d_4} = \frac{2 \cdot 200 \cdot 1200}{200 + 1200} = 342.857 \; mm$$

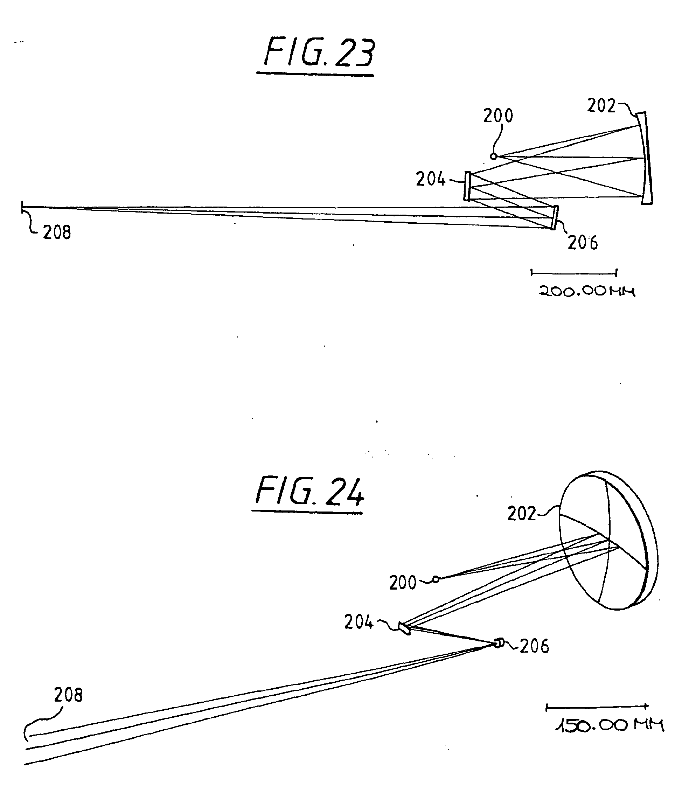

In Figur 23 ist das Gesamtsystem mit den zuvor angegebenen Größen bis zur Retikelebene im yz-Schnitt gezeigt. Eingezeichnet sind für die zentrale Feldwabe (0,0) und die beiden äußersten Feldwaben jeweils der Mitten- und die beiden Randstrahlen. Von jeder Wabe wird eine sekundäre Lichtquelle in der Pupillenebene erzeugt.

In Figur 24 ist das Gesamtsystem mit einem x-z-Fan von Strahlen, der die zentrale Wabe trifft, dargestellt.

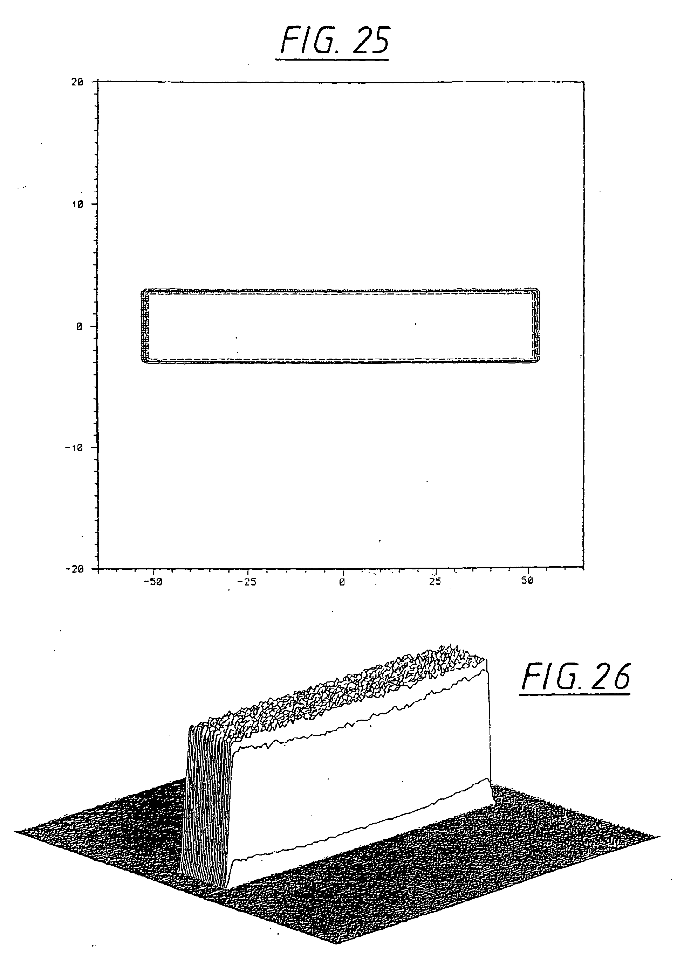

Die Figuren 25 und 26 zeigen die Ausleuchtung des Retikels mit dem Rechteckfeld (-52.5 mm < x < + 52.5 mm; - 3.0 mm < x < + 3.0 mm) gemäß der Figuren 25 bzw. 26 in Höhenlinien- und 3D-Darstellung. Die einzelnen Teilbilder werden auch bei den ausgedehnten sekundären Lichtquellen, die sich durch die Pinch-Plasma-Quelle ergeben, in der Retikelebene optimal überlagert, da eine Pupillenwabenplatte verwendet wird.

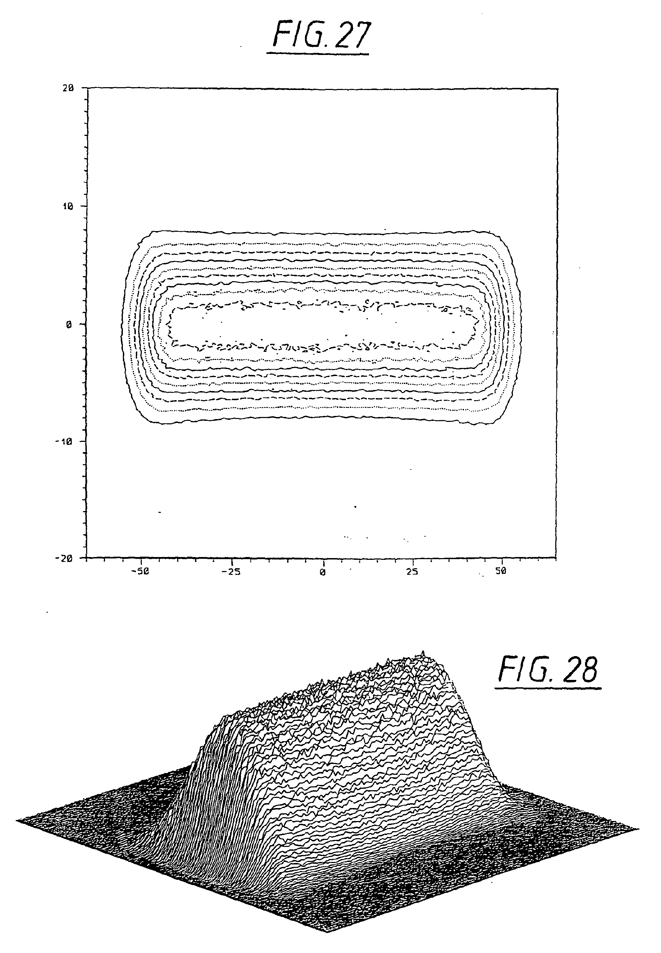

Im Vergleich hierzu ist in Figur 27 und 28 die Ausleuchtung des Retikels ohne Pupillen-Wabenplatte in Höhenlinien- und 3D-Darstellung gezeigt. Die Teilbilder der Feldwaben werden aufgrund der endlichen Apertur an der Feldwabenplatte unscharf abgebildet.

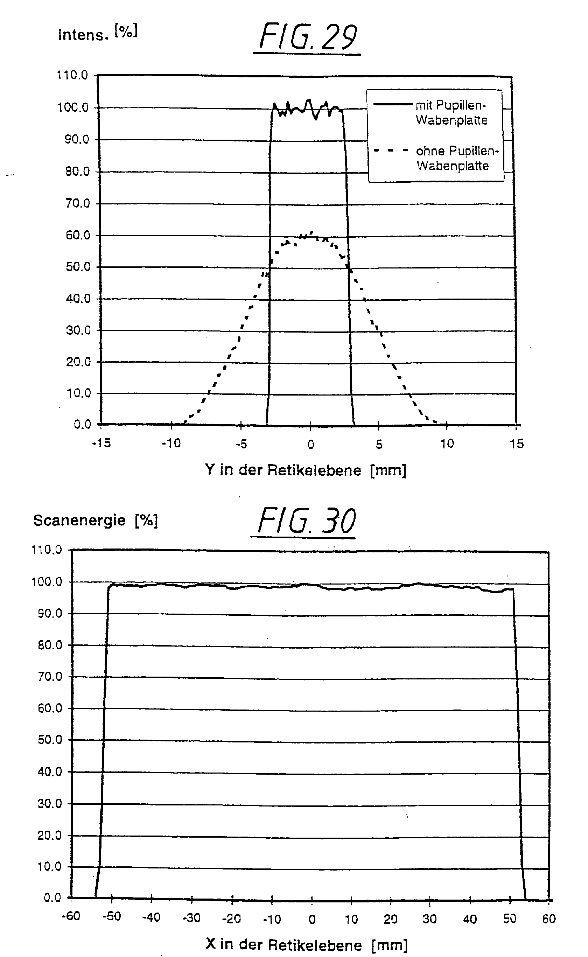

Figur 29 zeigt einen Intensitätsschnitt parallel zur y-Achse bei x = 0.0 mit und ohne Pupillen-Wabenplatte. Während mit Pupillen-Facetten ein ideales Rechteck-Profil entsteht, zerläuft das Profil ohne die Pupillen-Facetten.

Figur 30 zeigt die für den Lithographie-Prozeß entscheidende integrale Scan-Energie, d.h. die Integration der Intensität entlang des Scan-Weges. Deutlich zu erkennen die absolut homogene integrale Scan-Energie.

In Figur 31 wird die Pupillenausleuchtung der Austrittspupille in der Feldmitte dargestellt. Entsprechend der Wabenverteilung ergeben sich kreisrunde Intensitätspeaks in der Pupillenausleuchtung. Die maximale Apertur beträgt $NA_{Ret}$ = 0.025.

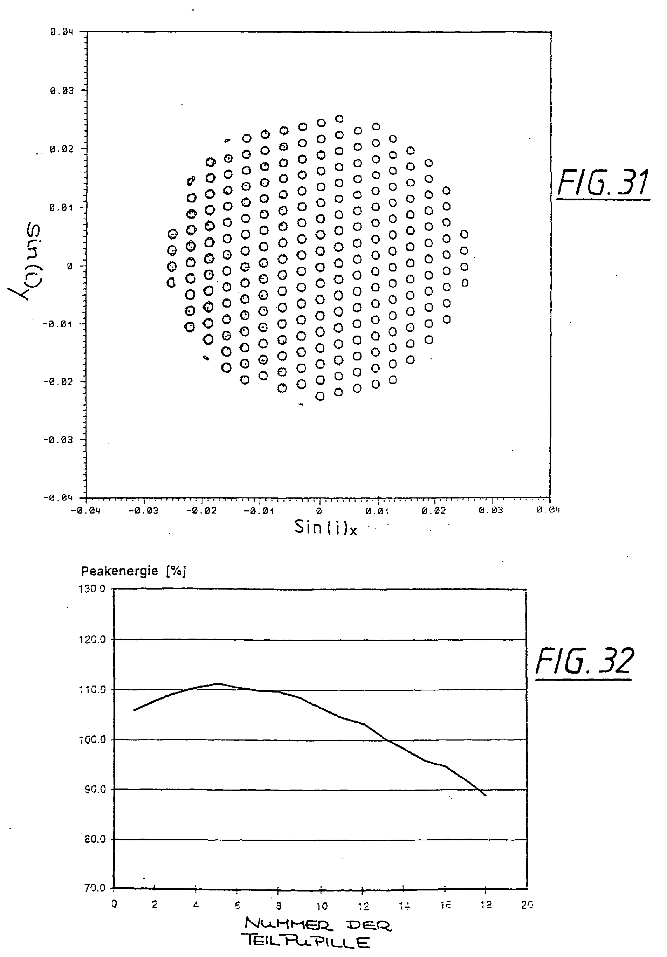

In Figur 32 ist die Gesamtenergie der Teilpupillen entlang der y-Achse gezeigt. Die Intensitätsverteilung in der Pupille weist aufgrund des geknickten Strahlenganges einen y-Tilt auf. Aufgetragen ist die Gesamtenergie der Teilpupillen, die auf der y-Achse liegen. Die Gesamtenergie der einzelnen Teilpupillen kann über die Reflektivität der einzelnen Facetten bzw. Waben eingestellt werden, so daß die Energie der Teilpupillen zumindest rotationssymmetrisch gesteuert werden kann. Eine andere Möglichkeit, dies zu erreichen, besteht darin, die Reflektivität des Kollektorspiegels ortsabhängig auszulegen.

Nachfolgend werden Ausführungsformen der Erfindung, die beispielhaft unterschiedliche Lichtquellen verwenden, beschrieben.

In den Fig. 33-39 wird eine weitere Ausführungsform der Erfindung einer Laser-Plasma-Quelle als Lichtquelle ausführlich erläutert. Wird die Feldwabenplatte plan ausgebildet, so ist die Apertur in der Retikelebene ($NA_{Soll}$ = 0.025) durch den Ellipsoid- bzw. Kollektorspiegel vorgegeben. Da der Abstand Lichtquelle - Ellipsoid- bzw. Kollektorspiegel mindestens 100 mm betragen sollte, um Verschmutzungen zu vermeiden, ergibt sich ein fester Zusammenhang von Baulänge und Sammelwirkungsgrad, wie in nachfolgender Tabelle niedergelegt:

Tabelle 1

| Baulänge L | Sammelwinkel θ | Sammelwirkungsgrad π (0° - 90°) |
|---|---|---|
| 1000 mm | 14.3° | 2 % - 12 % |
| 2000 mm | 28.1° | 6 % - 24 % |
| 3000 mm | 41.1° | 12 % - 35 % |
| 4000 mm | 53.1° | 20 % - 45 % |
| 5000 mm | 90.0° | 50 % - 71 % |

Wie hieraus zu ersehen, ist der Sammelwirkungsgrad bei vertretbaren Baulängen von 3000 mm nur 35 %.

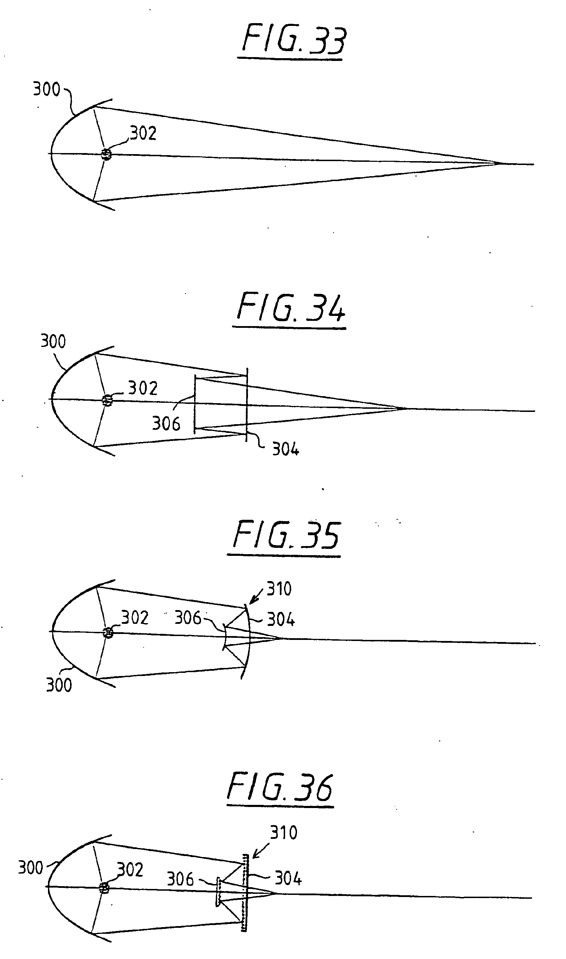

Um bei vertretbaren Baulängen hohe Sammelwirkungsgrade zu erzielen, ist in der besonders vorteilhaften Ausführungsform der Erfindung gem. Fig. 33-39 die Beleuchtungseinrichtung als Tele-System ausgebildet.

Bei der dargestellten Ausführungsform wird als Lichtquelle eine Laser-Plasma-Quelle verwandt, wobei sich die Feldwabenplatte im konvergenten Strahlengang eines Kollektorspiegels, der die Lichtquelle auf das Retikel abbildet, befindet.

Bei dem nachfolgend betrachteten Ausführungsbeispiel entspricht die Form der Waben der Feldwabenplatte der Form des Feldes, wobei zur Bestimmung der Wabengröße der Feldbogen des Ringfeldes zu einem Rechteck aufgezogen wird.

In den ausgeführten Beispielen ergibt sich für das

| Rechteckfeld | x = 2 πr 60°/360° = 104.7 mm ≈ 105 mm |
|---|---|
| | y = 6 mm |
| Als Wabengröße wird gewählt: | x = 17.5 mm |
| | y = 1 mm. |

Prinzipiell ist die Wabengröße frei wählbar. Es gilt: je mehr Waben, desto besser, allerdings auch: je mehr Waben um so kleiner die einzelne Wabe. Je kleiner die Waben im Vergleich zum Feld sind, desto größer muß der Abbildungsmaßstab zwischen erster Wabe und Feld sein.

Wenn die Feldwaben ein sehr hohes Aspektverhältnis aufweisen, ist es vorteilhaft, wenn die Feldwabenzeilen versetzt zueinander angeordnet sind. Durch die versetzten Wabenzeilen kommt es zu einer gleichmäßigen Anordnung der sekundären Lichtquellen auf der Pupillenwabenplatte. Im Falle eines Aspektverhältnisses von z.B. 1:16 ist es günstig, die Wabenzeilen jeweils um ¼ der Wabenlänge zu verschieben.

Auf der Pupillenwabenplatte ergeben sich sekundäre Lichtquellen, die entsprechend der Verteilung der Feldwaben auf der Feldwabenplatte angeordnet sind. Für eine Punktlichtquelle ist die Pupillenwabenplatte mit kleinen Intensitätspeaks beleuchtet. Um die Baulänge des Beleuchtungssystems zu reduzieren, wird das Beleuchtungssystem als Teleskopsystem ausgebildet. Eine Ausführungsform um ein derartiges Teleskopsystem auszubilden, besteht darin, die Waben der Feldwabenplatte auf einer sammelnden Fläche, die Waben der Pupillenwabenplatte auf einer zerstreuenden Fläche anzuordnen. Dabei werden die Flächennormalen der Wabenmitten an die Flächennormalen der Trägerfläche angepaßt. Alternativ hierzu kann man den Waben auf einer Planplatte prismatische Anteile überlagern. Dies würde einer Fresnel-Linse als Trägerfläche entsprechen.

Der oben beschriebene Tele-Wabenkondensor stellt somit eine Überlagerung von klassischem Tele-System und Wabenkondensor dar. Die Kompression von Feldwabenplatte zu Pupillenwabenplatte ist so lange möglich, bis die sekundären Lichtquellen überlappen. Für die Laser-Plasma-Quellen mit einem kleinem Lichtleitwert und Quelldurchmesser 0.05 mm kann die Fläche von Feldwabenplatte zu Pupillenwabenplatte in großen Bereichen komprimiert werden.

In den Figuren 33 bis 36 sind schematisch verschiedene Anordnungen gezeigt, aus denen die drastische Baulängenverkürzurig, die mit einem Tele-System erreicht werden kann, deutlich wird.

Figur 33 zeigt eine Anordnung ausschließlich mit Kollektorspiegel 300 und Laser-Plasma-Lichtquelle 302.

Mit einer planaren Anordnung von Kollektorspiegel, Feldwabenplatte 304 und Pupillenwabenplatte 306, wie in Fig. 34 dargestellt, läßt sich die Baulänge nur um den gefalteten Lichtweg verkürzen. Da der Lichtleitwert einer Punktquelle nahezu Null ist, ist die Feldwabenplatte 304 zwar voll, die Pupillenwabenplatte 306 jedoch nur mit einzelnen Peaks ausgeleuchtet.

Bringt man die Waben jedoch auf gekrümmte Trägerflächen auf, d.h. gestaltet das System als Tele-System mit einem sammelnden und einem zerstreuenden Spiegel, wie in Fig. 35 gezeigt, so läßt sich die Baulänge verkürzen und die Ausleuchtung auf der Pupillenwabenplatte komprimieren.

Bei der Ausführung gemäß Fig. 36 sind die einzelnen Waben als auf einer ebenen Trägerfläche gekippt angeordnet.

Die Waben der Pupillenwabenplatte haben die Aufgabe, bei ausgedehnten sekundären Lichtquellen die Felder auf dem Retikel korrekt zu überlagern. Liegt jedoch eine hinreichend gute Punktlichtquelle vor, so ist die zweite Wabenplatte nicht erforderlich. Die Feldwaben können dann entweder auf dem sammelnden oder auf dem zerstreuenden Telespiegel aufgebracht werden. Befinden sich die Feldwaben auf dem sammelnden Telespiegel, so können sie konkav oder plan ausgeführt sein. Auf dem zerstreuenden Telespiegel können die Feldwaben konvex, konkav oder plan ausgeführt sein. Sammelnde Waben führen zu einer reellen Pupillenebene; zerstreuende Waben zu einer virtuellen Pupillenebene.

Kollektorlinse 300 und Tele-Wako bzw. Tele-System 310 erzeugen in der Bildebene des Beleuchtungssystems die vorgegebene rechteckige Feldausleuchtung von 6 mm x 105 mm mit korrekter Apertur NA = 0.025. Wie in den vorausgegangenen Beispielen, wird mit Hilfe einer oder mehrerer zwischen Tele-Wako 310 und Retikel 312 angeordneten Feldlinsen 314 das Ringfeld geformt, die Eintrittspupille des Objektivs getroffen und die für den Belichtungsprozeß notwendige Homogenität der Feldausleuchtung gewährleistet.

Schnittstelle für das Design der Feldlinse' 314 ist die Ebene der sekundären Lichtquellen: Diese muß durch die Feldlinse 314 in die Eintrittspupille des Objektivs abgebildet werden . In der Pupillenebene dieser Abbildung, die der Retikelebene entspricht, muß das Ringfeld erzeugt werden.

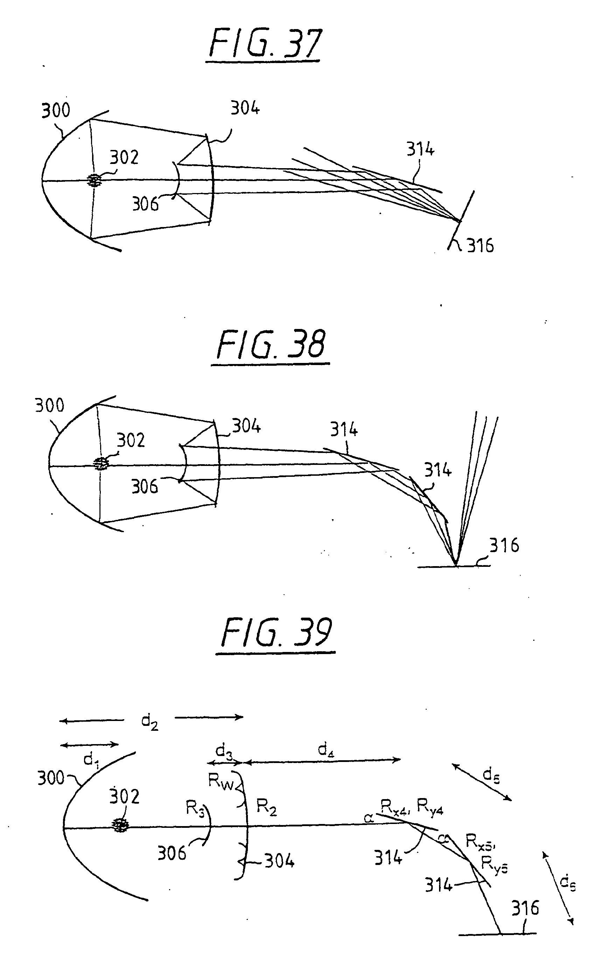

In Fig. 37 ist eine Ausführungsform der Erfindung mit nur einem Feldspiegel 314 gezeigt. Bei der Ausführungsform mit einem Feldspiegel kann das Ringfeld erzeugt und die Eintrittspupille getroffen werden. Da das Retikel 316 jedoch nur unter 2.97° getroffen wird, besteht die Gefahr, daß das Lichtbüschel in das Beleuchtungssystem zurückläuft. In einer besonders vorteilhaften Ausführungsform ist vorgesehen, als Feldspiegel zwei grazingincidence-Spiegel zu verwenden. Hierdurch wird das Ringfeld nochmals gedreht und das Beleuchtungssystem "hinter" den Feldlinsen 314 verlassen.

Durch die Verwendung von zwei Feldspiegel hat man zudem mehr Freiheitsgrade, um Telezentrie und Feldausleuchtung einzustellen.

Nunmehr soll das Design von Tele-Systemen anhand von Ausführungsbeispielen beschrieben werden, wobei die Zahlenangaben keinerlei Beschränkung des erfindungsgemäßen Systems darstellen sollen.

Bei dem ersten Ausführungsbeispiel eines Tele-Systems umfaßt dieses eine Kollektoreinheit, einen zerstreuenden und einen sammelnden Spiegel sowie Feldlinsen, wobei die Waben nur auf dem ersten Telespiegel angebracht sind. Alle Waben sind identisch und liegen auf einer gekrümmten Trägerfläche.

Die verwandten Parameter sind in Fig. 39 dargestellt und werden wie nachfolgend gewählt:

- Ringfeld: R = 100 mm, Segment = 60°, Feldhöhe ± 3.0 mm.
- Lage der Eintrittspupille: $S_{EP}$ = 1927.4 mm. Dies entspricht einem Hauptstrahlwinkel von $i_{HS}$ = 2.97° für y = 100 mm.
- Apertur am Retikel: NA = 0.025.
- Apertur an der Quelle: NA = 0.999.
- Abstand Quelle-Kollektorspiegel: $d_1$ = 100.0 mm.
- Wabengröße auf dem ersten Telespiegel 1 mm x 17.5 mm.
- $d_3$ = 100 mm
- Kompressionsfaktor $\emptyset_{1.Wabe}$ / $\emptyset_{2.Wabe}$ = 4:1.
- Kippwinkel $\alpha$ der grazing incidence Spiegel $\alpha$ = 80°.
- Kollektorspiegel ist als Ellipsoid mit $R_K$ und $Ex_K$ ausgebildet.
- Trägerfläche $R_2$ und $R_3$: sphärisch.
- Wabenradius $R_W$: sphärisch.
- Feldspiegel torisch ohne konzentrischen Anteil: $R_{4x}$, $R_{4y}$, $R_{5x}$, $R_{5y}$.

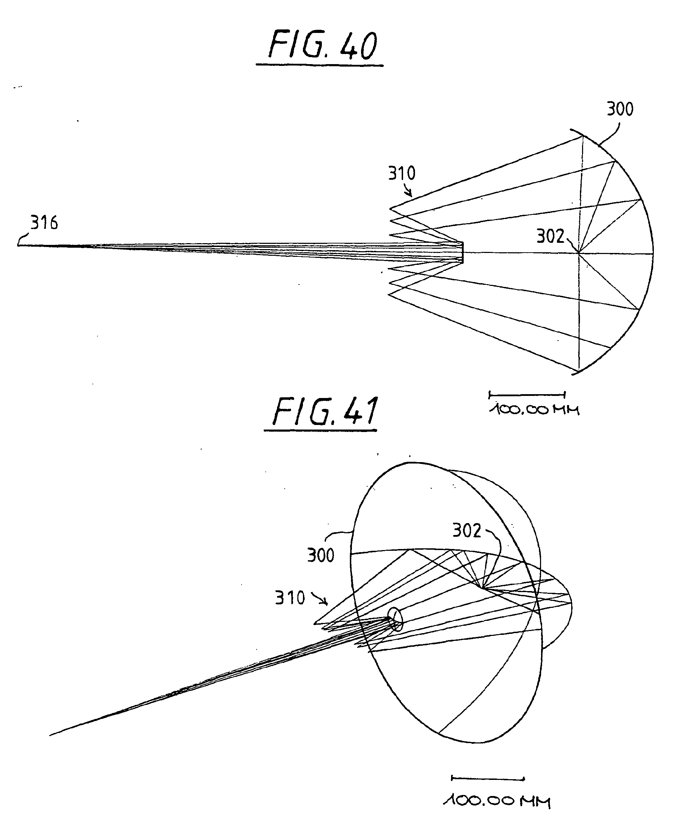

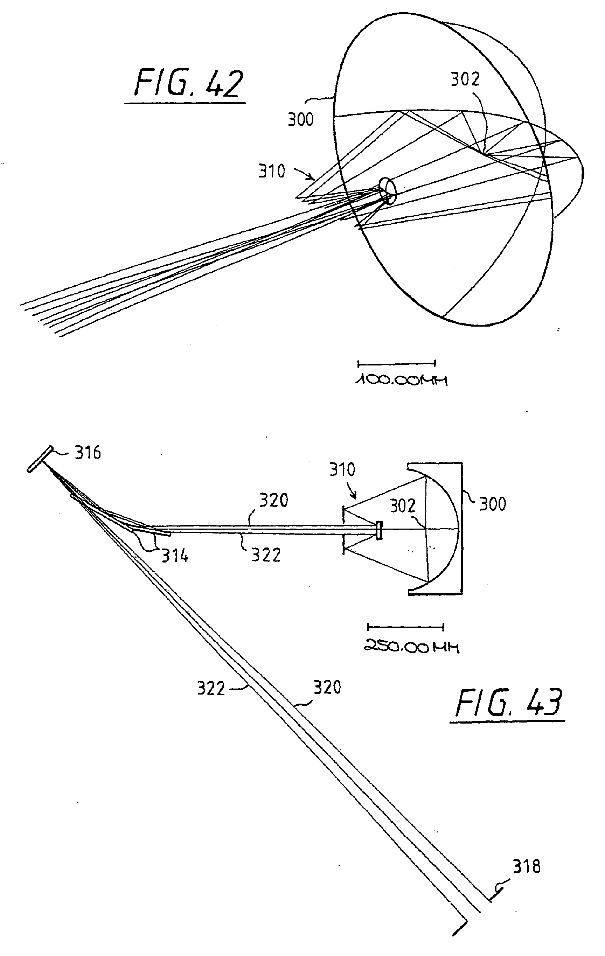

Figur 40 zeigt eine Anordnung eines Tele-Systems mit Kollektorspiegel, wobei die Spiegel unstrukturiert sind, d.h. keine Waben umfassen. Die beiden Spiegel zeigen einen Kompressionsfaktor 4:1. Die Baulängenverkürzung durch das Tele-System ist offensichtlich. Mit Tele-System beträgt die Baulänge 852.3 mm, ohne Tele-System würde sie 8000.0 mm betragen. In Figur 41 ist ein Fan von Strahlen in der x-z-Ebene für das System gemäß Figur 40 gezeigt.

Figur 42 stellt wiederum einen Fan von Strahlen in der x-z-Ebene dar, wobei die Spiegel des Systems gemäß Fig. 40 nunmehr strukturiert sind und Feldwaben aufweisen. Durch die Feldwaben auf dem ersten Spiegel des Tele-Systems entstehen auf dem zweiten Spiegel des Tele-Systems sekundäre Lichtquellen. Im Feld werden die Büschel korrekt überlagert und ein Streifen mit -52.5 mm < x < +52.5 mm homogen ausgeleuchtet.

In Figur 43 ist das Gesamtsystem bis zur Eintrittspupille des Objektivs dargestellt. Das Gesamtsystem umfaßt: Lichtquelle 302, Kollektorspiegel 300, Tele-Wako 310, Feldspiegel 314, Retikel 316 und Eintrittspupille des Projektionsobjektives 318. Die eingezeichneten Randstrahlen 320, 322 treffen sich auf dem Retikel und sind bis zur Eintrittspupille des Objektivs gezeichnet.

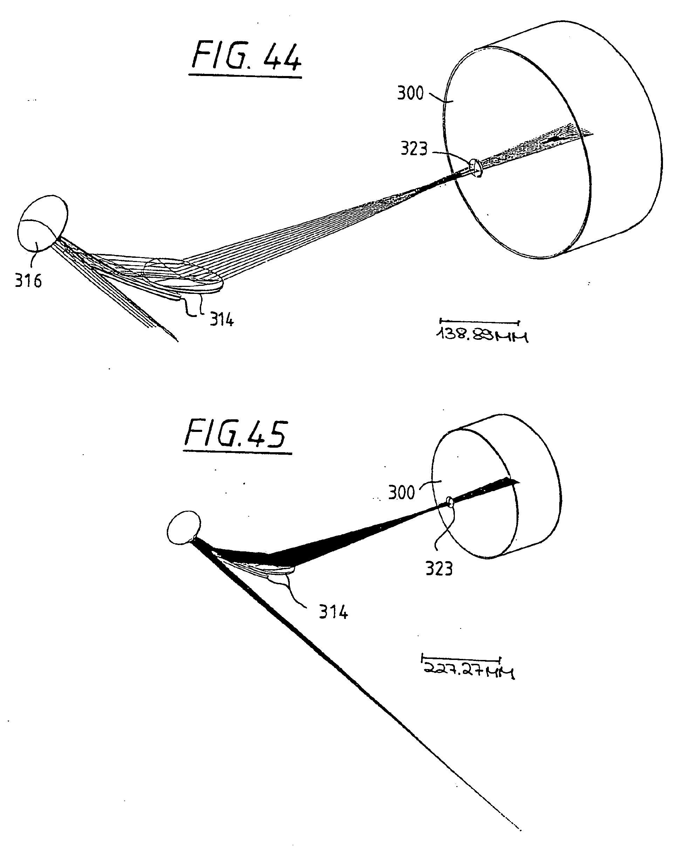

Figur 44 zeigt einen x-z-Fan von Strahlen einer Konfiguration gemäß Figur 43, der die zentrale Feldwabe 323 durchtritt. Dieses Büschel ist zwar physikalisch nicht sinnvoll, da es vom zweiten Tele-Spiegel vignettiert werden würde, zeigt aber gut den Weg des Lichtes. An den Feldspiegeln 314 sieht man, wie durch den zweiten Feldspiegel die Orientierung des Ringfeldes umgedreht wird. Die Strahlen können nach der Reflexion am Retikel 316 ungestört ins nicht dargestellte Objektiv laufen.

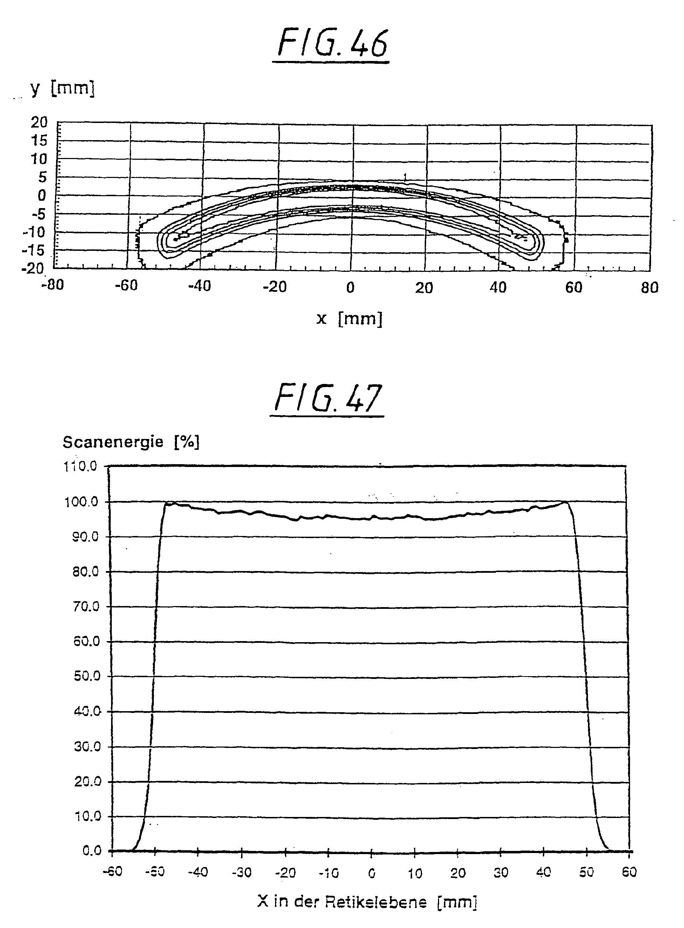

Figur 45 zeigt ein Strahlbüschel, das die zentrale Feldwabe 323 wie in Fig. 44 durchtritt, entlang der optischen Achse läuft und in die Mitte der Eintrittspupille fokussiert wird.

Figur 46 beschreibt die Ausleuchtung des Retikelfeldes mit dem durch die Konfiguration gemäß der Figuren 40 bis 45 erzeugten Ringfeld (R = 100 mm, Segment = 60°, Feldhöhe ± 3.0 mm).

In Figur 47 wird die für den Lithographie-Prozeß entscheidende integrale Scan-Energie (Integration der Intensität entlang des Scanweges) einer Anordnung gemäß den Figuren 40 bis 46 dargestellt. Die integrale Scan-Energie variiert zwischen 95 % und 100 %. Die Uniformity beträgt somit ± 2.5 %.

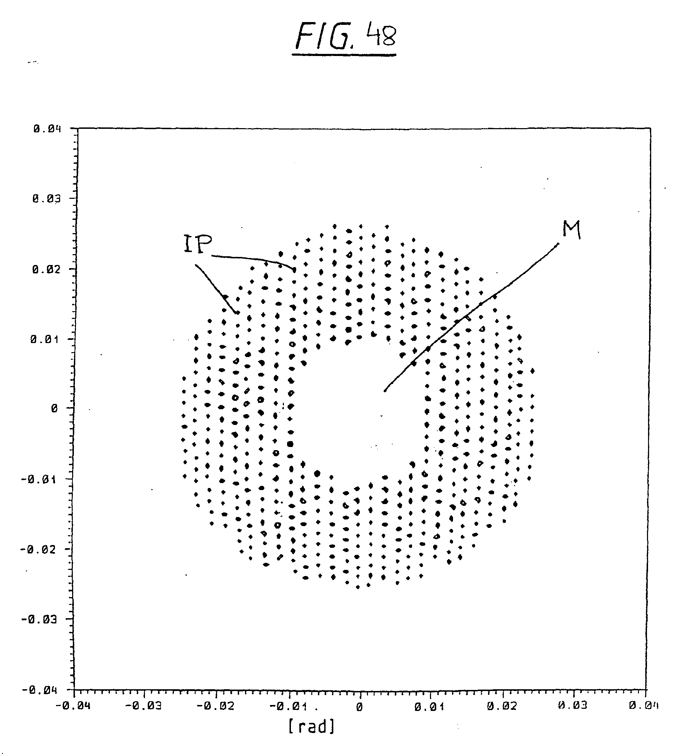

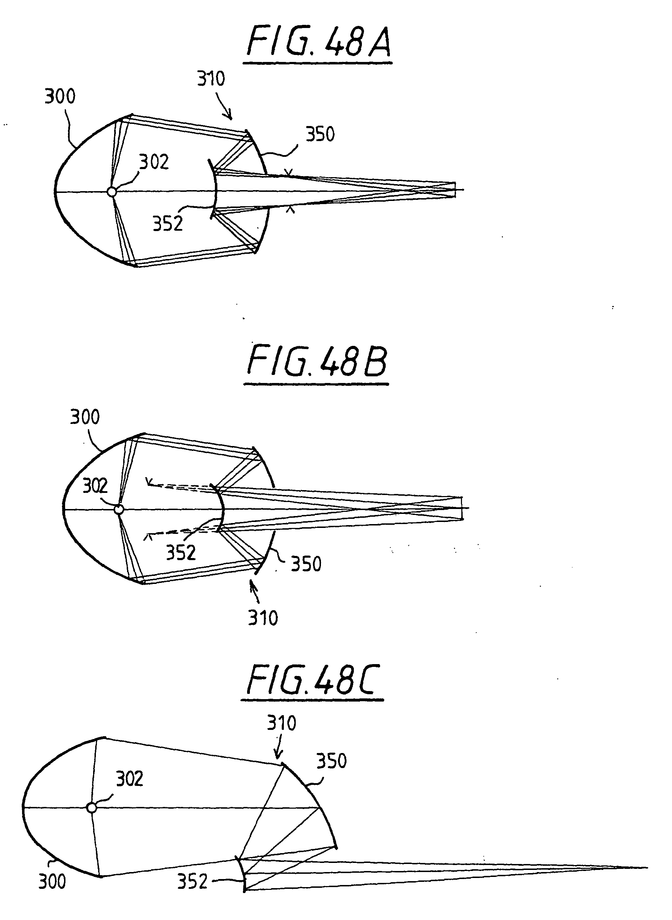

In Figur 48 ist die Pupillenausleuchtung in der Feldmitte gezeigt. Die Strahlwinkel sind auf den Schwerstrahl bezogen. Entsprechend der Wabenverteilung ergeben sich kreisrunde Intensitätspeaks IP in der Pupillenausleuchtung. Die Obskuration in der Mitte M ist durch den zweiten Telespiegel bedingt.

Das in den Figuren 31 bis 48 beschriebene Beleuchtungsssystem hat den Vorteil, daß der Sammelwinkel sich ohne weiteres auf über 90° erhöhen läßt, da das Ellipsoid die Quelle auch umschließen kann.

Des weiteren kann durch das Tele-System die Baulänge eingestellt werden. Begrenzt wird eine Baulängenreduktion durch die Winkelakzeptanz der Schichten und die Abbildungsfehler von Flächen mit starker optischer Wirkung.

Kann für Punktlichtquellen bzw. Quellen mit sehr kleiner Ausdehung eine Anordnung mit nur einer Feldwabenplatte realisiert werden, beispielsweise bei Laser-Plasma-Quellen mit Durchmesser ≤ 50 μm, so können die Waben auf dem Sammelspiegel 380 des Tele-Systems oder auf dem zerstreuenden zweiten Telespiegel 352 angebracht werden. Dies ist in Fig. 48A-48C gezeigt.

Die Anbringung auf dem zweiten Telespiegel 352 hat mehrere Vorteile: Bei sammelnden Waben entsteht eine reelle Pupillenebene in "Luft", die frei zugänglich ist, wie in Fig. 48A gezeigt.

Bei zerstreuenden Waben entsteht zwar eine virtuelle Pupillenebene, die nicht zugänglich ist, wie in Fig. 48B gezeigt. Die negative Brennweite der Waben kann jedoch vergrößert werden.

Um eine Obskuration zu vermeiden, können, wie in Fig. 48C gezeigt, die Spiegel des Tele-Systems 350, 352 gegeneinander gekippt sein, so daß die Strahlenbüschel sich nicht in die Quere kommen.

Nachfolgend soll ein zweites Ausführungsbeispiel für ein Tele-System beschrieben werden, das einen Planfacetten-Wabenkondensor umfaßt. Das nachfolgend beschriebene System zeichnet sich insbesondere dadurch aus, daß die Kollektoreinheit mit einem Spiegel eine Tele-Einheit bildet. Die Sammelwirkung des Tele-Systems wird dann vollständig auf den Kollektorspiegel übertragen. Eine derartige Ausgestaltung spart einen Spiegel ein.

Des weiteren sind beim Planfacetten-Wabenkondensor die Waben plan ausgebildet.

Ein solches System weist eine hohe Systemeffizienz von 27 % auf mit zwei normal-incidence-Spiegeln (65 %) und zwei grazing-incidence-Spiegeln (80 %).

Des weiteren kann eine große Sammeleffizienz realisiert werden, wobei der Sammelraumwinkel 2 $\pi$ beträgt, der sich aber noch erweitern läßt.

Aufgrund des Zick-Zack-Strahlengangs treten Obskurationen in der Pupillenausleuchtung nicht auf. Außerdem ist bei der beschriebenen Ausführungsform die Baulänge leicht einstellbar.

Der Kollektor- bzw. Ellipsoidspiegel sammelt das von der Laser-Plasma-Quelle abgestrahlte Licht und bildet die Quelle auf eine sekundäre Lichtquelle ab. Eine Vielzahl einzelner planer Feldwaben sind gekippt auf einer Trägerplatte angeordnet. Die Feldwaben zerlegen das kollimierte Lichtbüschel in Teilbündel und überlagern diese in der Retikelebene. Die Form der Feldwaben entspricht dem Rechteckfeld des auszuleuchtenden Feldes. Des weiteren weist das Beleuchtungssystem zwei grazing-incidence-Toroidspiegeln auf, die das Ringfeld formen, die Eintrittspupille des Objektivs korrekt ausleuchten und die Homogenität der Feldausleuchtung entsprechend dem Belichtungsprozeß gewährleisten.

Im Gegensatz zum ersten Ausführungsbeispiel eines Tele-Systems mit Kollektoreinheit sowie zwei weiterer Spiegeln wird bei vorliegend beschriebener Ausführungsform die Laser-Plasma-Quelle alleine durch den Ellipsoidspiegel in die sekundäre Lichtquelle abgebildet. Dies spart einen normal-incidence-Spiegel ein und läßt die Verwendung von planen Feldwaben zu. Eine derartige Einsparung setzt voraus, daß keine Pupillenwaben notwendig sind, d. h. die Lichtquelle im wesentlichen punktförmig ist.

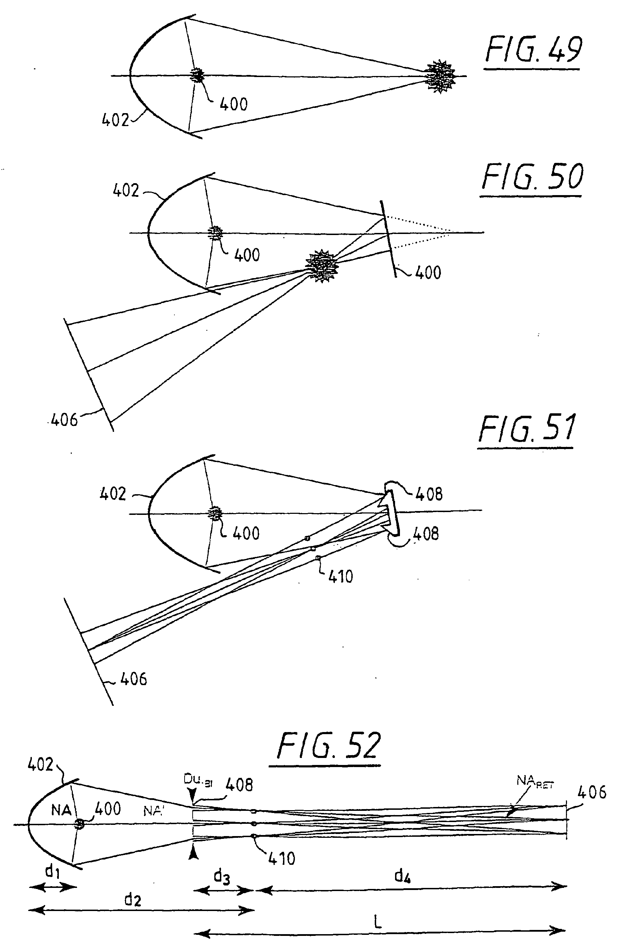

Die Wirkungsweise wird anhand der Fig. 49-51 näher beschrieben.

Figur 49 zeigt die Abbildung der Laser-Plasma-Quelle 400 durch den Ellipsoidspiegel 402. Es wird eine sekundäre Lichtquelle 410 ausgebildet.

In der Abbildung Figur 50 lenkt ein gekippter Planspiegel 404 das Lichtbüschel um und leitet es am Ellipsoidspiegel vorbei zur Retikelebene 406.

In der Abbildung Figur 51 zerschneiden gekippte Feldwaben 408 das Lichtbüschel und überlagern die Teilbündel in der Retikelebene. Dadurch wird eine Vielzahl von sekundären Lichtquellen 410 erzeugt, die gleichmäßig über die Pupille verteilt sind. Die Kippwinkel der einzelnen Feldwaben 408 entsprechen an den Aufpunkten der Feldwaben den Krümmungen eines Hyperboloids, das zusammen mit dem Ellipsoidspiegel die Laser-Plasma-Quelle in die Retikelebene abbildet. Die zerstreuende Wirkung der Tele-Einheit wird somit durch die Kippwinkel der Feldwaben bzw. Facetten aufgebracht.

In Figur 52 sind die Abkürzungen eingezeichnet, wie sie in der nachfolgenden Systemableitung verwendet werden. Zur besseren Darstellung wurde das System linear aufgezogen.

Für das nachfolgend beschriebene Ausführungsbeispiel werden folgende Größen zugrunde gelegt, ohne daß in den Zahlenangaben eine Beschränkung zu sehen wäre:

- Ringfeld: R = 100 mm, Segment 60°, Feldhöhe $\pm$ 3.0 mm, was einem Rechteckfeld von 105 mm x 6 mm entspricht.
- Apertur am Retikel: $NA_{Ret}$ = 0.025.
- Apertur an der Quelle: $NA_{Quelle}$ = 0.999.
- $d_1$ = 100.0 mm.
- Baulänge L = $d_3$ + $d_4$ = 1400 mm.
- Anzahl der Waben innerhalb einer x-Zeile des Blendendurchmessers = 4.

Die Größen sind folgendermaßen miteinander verknüpft:

$$NA_{Ret} = \frac{DU_{BL}/2}{L} \qquad\qquad \Rightarrow DU_{BL} = 2 \cdot L \cdot NA_{Ret}$$

$$\frac{DU_{BL}}{x_{Wabe}} = 4.0 \qquad \Rightarrow x_{Wabe} = \frac{DU_{BL}}{4.0}$$

$$\beta_{Wabe} = \frac{x_{Feld}}{x_{Wabe}} = \frac{d_4}{d_3} \qquad\qquad \Rightarrow \beta_{Wabe} = \frac{x_{Feld}}{x_{Wabe}}$$

$$\Rightarrow d_4 = d_3 \cdot \beta_{Wabe}$$

$$L = d_3 + d_4 \qquad \Rightarrow d_3 = \frac{L}{1 + \beta_{Wabe}}$$

$$NA' = \frac{DU_{BL}/2}{d_3} \qquad\qquad \Rightarrow NA' = \frac{DU_{BL}/2}{d_3}$$

$$\tan(\theta) = \frac{|1-Ex| \cdot \sin|\theta'|}{2\sqrt{Ex} - |1 - Ex| \cdot \cos|\theta'|} \qquad \Rightarrow Ex = f(NA_{QU}, NA')$$

$$Ex = \left(\frac{sk - s1}{sk + s1}\right)^2 = \left(\frac{d_2 - d_1}{d_2 + d_1}\right)^2 \qquad\qquad \Rightarrow d2 = d1 \cdot \frac{1 + \sqrt{Ex}}{1 - \sqrt{Ex}}$$

$$Ex = 1 - \frac{R}{a} \qquad \Rightarrow R = \frac{d_1 + d_2}{2} \cdot (1 - Ex)$$

Mit dem erfindungsgemäßen Verfahren zum Design eines Beleuchtungssystems unter Verwendung von planen Feldwaben und den vorgegebenen Größen läßt sich das System vollständig bestimmen.

Setzt man die Designvorhaben in die obigen Formeln ein, so ergeben sich die Systemparameter zu:

$$DU_{BL} = 2 \cdot L \cdot NA_{Ret} = 2 \cdot 1400 \; mm \cdot 0.025 = 70.0 \; mm$$

$$X_{Wabe} = \frac{DU_{BL}}{4.0} = \frac{70.0 \; mm}{4.0} = 17{,}5 \; mm$$

$$\beta_{Wabe} = \frac{X_{Feld}}{X_{Wabe}} = \frac{105.0\ mm}{17.5\ mm} = 6.0$$

$$d_3 = \frac{L}{1 + \beta_{Wabe}} = \frac{1400.0\ mm}{1 + 6.0} = 200.0\ mm$$

$$d_4 = d_3 \cdot \beta_{Wabe} = 200.0\ mm \cdot 6.0 = 1200.0\ mm$$

$$NA' = \frac{DU_{BL}/2}{d_3} = \frac{70.0\ mm/2}{200.0\ mm} = 0.175$$

$$Ex = f(NA_{QU}, NA') = 0.695$$

$$d_2 = d_1 \cdot \frac{1 + \sqrt{Ex}}{1 - \sqrt{Ex}} = 100.0\ mm \cdot \frac{1 + \sqrt{0.695}}{1 - \sqrt{0.695}} = 1101.678\ mm$$

$$R = \frac{d_1 + d_2}{2} \cdot (1 - Ex) = \frac{100.0\ mm + 1101.678\ mm}{2} \cdot (1 - 0.695) = 183.357\ mm$$

Die Feldlinsen sind ähnlich aufgebaut wie beim ersten Ausführungsbeispiel eines Tele-Systems, d.h., es werden als Feldlinsen wiederum zwei Toroidspiegel verwendet.

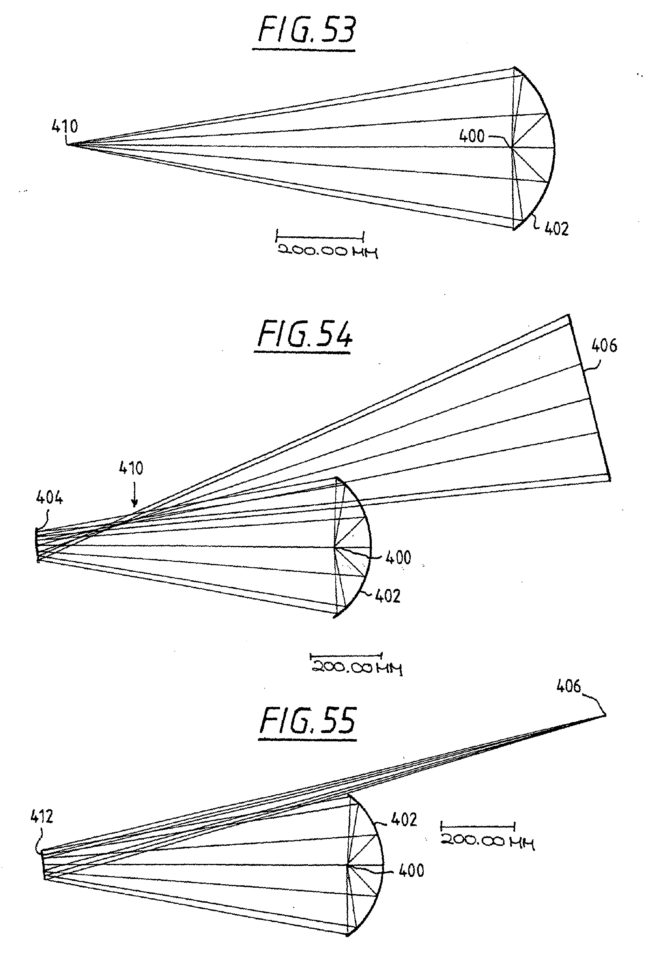

In den Fig. 53-58 werden die Strahlverläufe eines Systems mit den zuvor beispielhaft angegebenen Parametem dargestellt.

In Figur 53 ist der Strahlverlauf für einen Ellipsoidspiegel, der die Apertur NA = 0.999 aufnimmt und auf eine sekundäre Lichtquelle 410 abbildet, gezeigt.

Bei der Ausführungsform gemäß Figur 54 wird ein Planspiegel 404 am Ort der Feldwabenplatte, der das Büschel zurückspiegelt, angeordnet. Die Strahlen sind bis zur Retikelebene 406 verlängert. Die eine sekundäre Lichtquelle 410 liegt innerhalb des Strahlenbüschels.

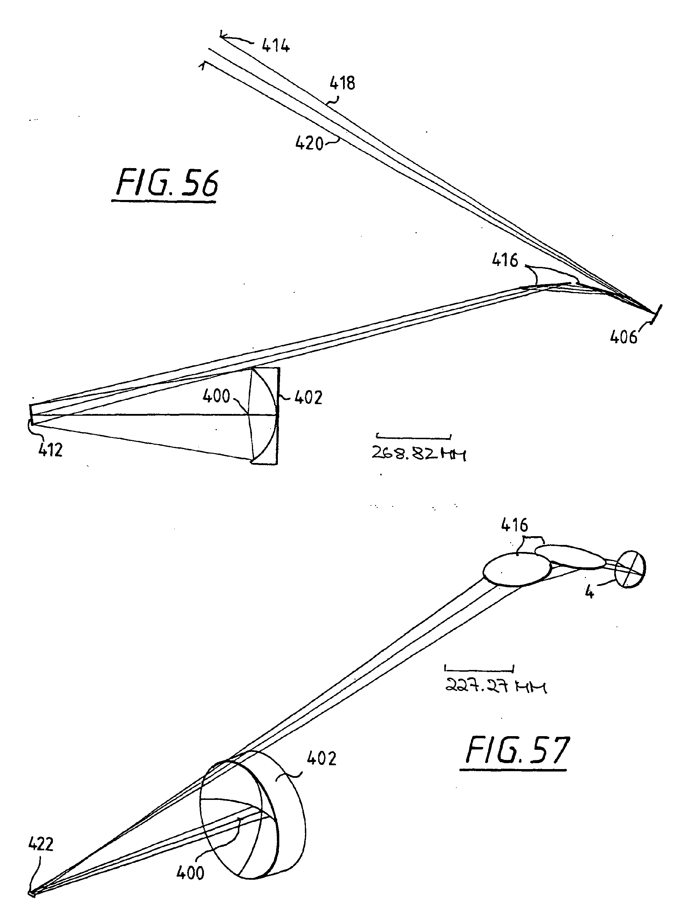

In Figur 55 schließlich ist der erfindungsgemäße Aufbau gezeigt, bei dem der Umlenkspiegel 404 durch die Feldwabenplatte 412 ersetzt wird. Eingezeichnet ist ein Fan von Strahlen, die jeweils durch die Mitten der einzelnen Feldwaben gehen. Diese Strahlen schneiden sich in der Retikelebene 406 auf der optischen Achse.

Figur 56 schließlich zeigt das Gesamtsystem bis zur Eintrittspupille 414 des Objektivs mit Feldlinsen 416. Die eingezeichneten Randstrahlen 418, 420 treffen sich auf dem Retikel 406 und sind bis zur Eintrittspupille des Objektivs weitergerechnet.

In Figur 57 ist für das System von Figur 56 ein x-z-Fan von Strahlen eingezeichnet, der die zentrale Feldwabe 422 trifft. Die Strahlen leuchten den Ring auf dem Retikel 406 mit der korrekten Orientierung aus.

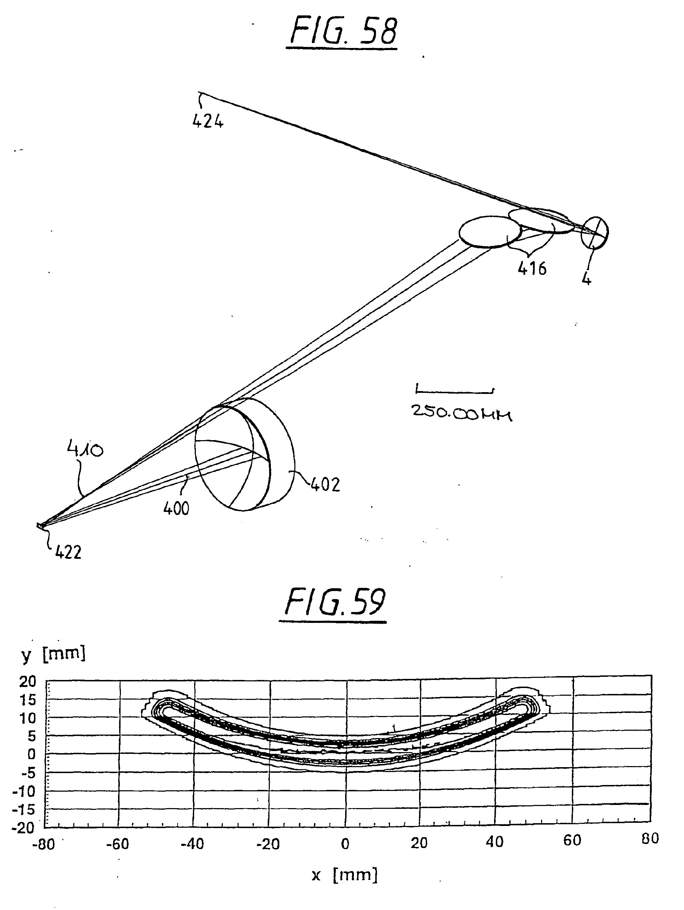

Bei Figur 58 wird zusätzlich die Eintrittspupille 424 des Projektionsobjektives dargestellt. Das eingezeichnete Strahlenbüschel läuft entlang der optischen Achse (Mittenbüschel) und wird somit in die Mitte der Eintrittspupille fokussiert.

In Figur 59 wird die Ausleuchtung des Retikels mit einem Ringfeld (R = 100 mm, Segment = 60°, Feldhöhe ± 3.0 mm) bei Zugrundelegung einer Beleuchtungsanordnung gem. Fig. 52-58 gezeigt.

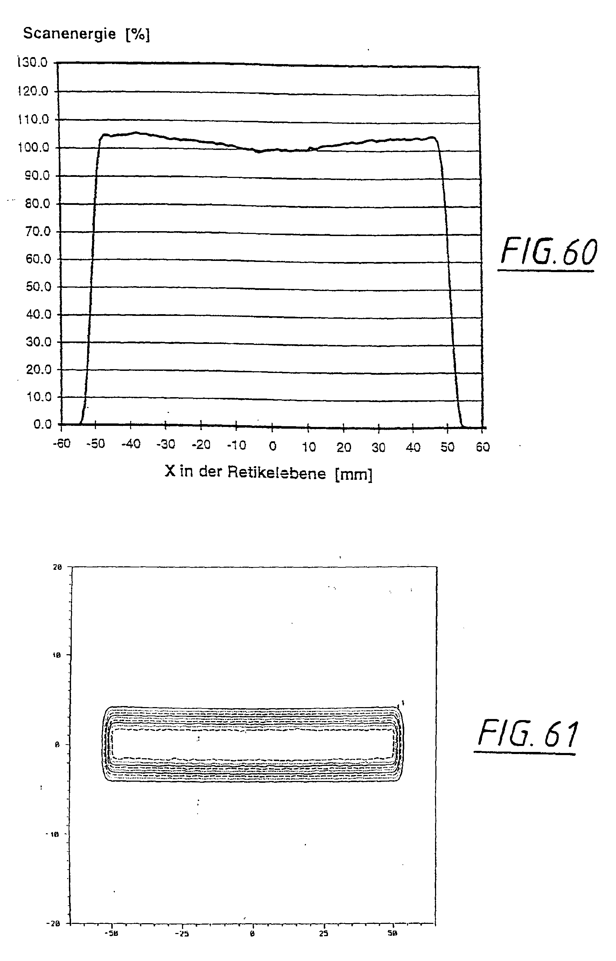

Die für den Lithographie-Prozeß entscheidende integrale Scan-Energie, d.h. die Integration der Intensität entlang des Scanweges, ist in Fig. 60 gezeigt. Die integrale Scanenergie variiert zwischen 100 % und 105 %. Die Uniformity bzw. Gleichmäßigkeit beträgt also ± 2.5 %.

Figur 61 stellt die Pupillenausleuchtung des zuvor beschriebenen Systems in der Feldmitte dar. Die Strahlwinkel sind auf den Schwerstrahl bezogen. Entsprechend der Feldwabenverteilung ergeben sich kreisrunde Intensitätspeaks in der Pupillenausleuchtung. Die Pupille ist voll gefüllt. Es gibt keine Mittenobskuration, da bei der beschriebenen zweiten Ausführungsform die Spiegel im Zick-Zack angeordnet sind.

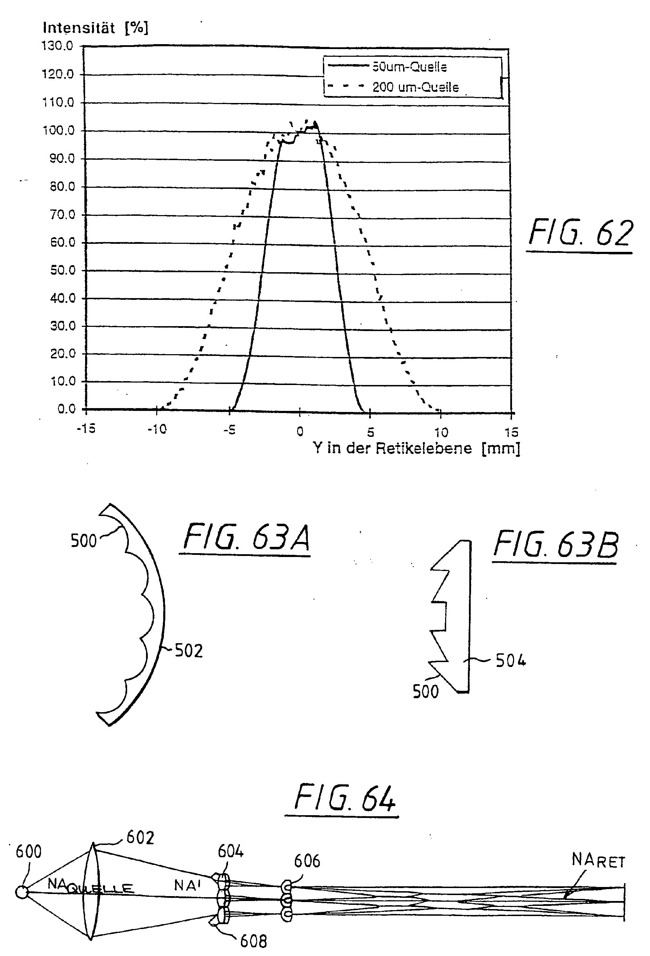

In Fig. 62 ist der Intensitätsverlauf in Scanrichtung bei Verwendung von zwei unterschiedlichen Laser-Plasma-Quellen gezeigt. Während mit nur einer Feldwabenplatte für die 50 μm-Quelle der erwünschte Rechteck-Verlauf erzielt wird, zeigt die 200 μm-Quelle zu den Rändern hin eine deutliche Verschmierung. Diese Quelle kann nicht mehr als punktförmig betrachtet werden. Die Verwendung eines zweiten facettierten Spiegels umfassend Pupillenwaben, wie beispielsweise bei der Pinch-Plasma-Quelle, wird zur korrekten Büschelüberlagerung in der Eintrittspupille des Objektives benötigt.

In den Fig. 63A + 63B sind zwei Möglichkeiten der Ausbildung der Feldwabenplatte gezeigt. Bei Fig. 63A sind die Waben 500 auf einer gekrümmten Trägerfläche 502 angeordnet. Dabei entspricht die Neigung der Waben der Tangentenneigung der Trägerfläche. Derartige Platten werden beispielsweise bei der ersten Ausführungsform eines erfindungsgemäßen Tele-Systems mit zwei Spiegeln und einem getrennten Kollektorspiegel beschrieben.

Sind die Feldwaben 500 plan ausgebildet, wie beispielsweise beim zweiten beschriebenen Ausführungsbeispiel, bei dem Kollektoreinheit und Feldwabenplatte zu einem Tele-System zusammengefaßt sind, so sind die einzelnen Feldwaben unter einem vorgegebenen Kippwinkel auf der Wabenplatte 504 angeordnet. Je nach Verteilung der Kippwinkel auf der Platte erhält man sammelnde oder zerstreuende Wirkung. Dargestellt ist eine Platte mit zerstreuender Wirkung.

Selbstverständlich können Wabenplatten mit planen Waben auch bei Systemen gemäß dem ersten Ausführungsbeispiel mit einer Kollektoreinheit und zwei Telespiegeln verwendet werden. Bei einem derartigen System sind dann die Waben auf dem einen Spiegel derart gekippt, daß sich eine zerstreuende Wirkung ergibt und auf dem anderen, daß sich eine sammelnde Wirkung einstellt.

Figur 64 zeigt eine Ausführungsform der Erfindung, die als refraktives System mit Linsen für Wellenlängen beispielsweise von 193 nm oder 157 nm ausgelegt ist. Das System umfaßt eine Lichtquelle 600, eine Kollektorlinse 602 sowie eine Feldwaben- und eine Pupillenwabenplatte 604, 606. Zur Einstellung des Lichtweges zwischen Feldwaben- und Pupillenwabenplatte 604, 606 dienen vor den Feldwaben angeordnete Prismen 608.

Mit der erfindungsgemäßen Vorrichtung bzw. dem erfindungsgemäßen Designverfahren wird erstmals eine Anordnung bzw. ein Designverfahren für Beleuchtungssysteme, die insbesondere in der EUV-Lithographie Verwendung finden, angegeben, bei dem eine uniforme Ausleuchtung eines Retikelfeldes bei gleichmäßiger Abbildung und Füllung der Eintrittspupille für Lichtquellen mit beliebiger Ausleuchtung A erzielt wird.

**Patentansprüche**

1.  Beleuchtungssystem für Wellenlängen ≤ 193 nm, insbesondere für die EUV-Lithographie, mit

    1.1 wenigstens einer Lichtquelle (1),
    1.2 wenigstens einem ersten Spiegel oder einer Linse, der bzw. die in erste Rasterelemente gegliedert ist;
    1.3 ein oder mehrere optische Elemente, die zwischen dem wenigstens einen Spiegel oder der einen Linse, der bzw. die in erste Rasterelemente (5) gegliedert ist und einer Retikelebene (14, 316, 406) angeordnet (ist) sind **dadurch gekennzeichnet, dass**
    1.4 die ersten Rasterelemente (5) des bzw. der Spiegel oder Linse (n) ein auf den Spiegel bzw. Linse einfallendes Strahlbüschel in eine Vielzahl von Teilbüscheln aufspaltet und unter einem ersten Ablenkwinkel ablenkt, wobei der erste Ablenkwinkel von wenigstens zwei Teilbüscheln verschieden ist.

2.  Beleuchtungssystem nach Anspruch 1, **dadurch gekennzeichnet, dass** je ein erstes Rasterelement eine sekundäre Lichtquelle erzeugt und dass das dem ersten Rasterelement zugeordnete Teillichtbüschel in Richtung der sekundären Lichtquelle abgelenkt wird.

3.  Beleuchtungssystem nach Anspruch 1 oder 2, **dadurch gekennzeichnet, dass** das erste Rasterelement ein Spiegel ist und der Ablenkwinkel des ersten Rasterelements durch einen Kippwinkel des ersten Rasterelements bestimmt wird.

4.  Beleuchtungssystem nach einem der Ansprüche 1 bis 3, **dadurch gekennzeichnet, dass** das Beleuchtungssystem einen Kollektorspiegel oder Kollektorlinse (n) (300,402) umfasst.

5.  Beleuchtungssystem nach Anspruch 4, **dadurch gekennzeichnet, dass** der Kollektorspiegel oder die Kollektodinse eine sammelnde Wirkung aufweist.

6.  Beleuchtungssystem nach einem der Ansprüche 1 bis 5, **dadurch gekennzeichnet, dass** die ersten Rasterelemente auf einer Platte (100) in Spalten und Zeilen angeordnet sind.

7. Beleuchtungssystem nach Anspruch 6, **dadurch gekennzeichnet, dass** die in benachbarten Zeilen angeordneten Rasterelemente gegeneinander verschoben sind.

8. Beleuchtungssystem nach einem der Ansprüche 1 bis 7, **dadurch gekennzeichnet, dass** das optische Element oder die optischen Elemente einen zweiten Spiegel oder eine zweite Linse mit zweiten Rasterelementen (9) umfasst.

9. Beleuchtungssystem nach Anspruch 8, **dadurch gekennzeichnet, dass** je ein erstes Rasterelement (5) zu je einem zweiten Rasterelement (9) korrespondieren und dass das durch das erste Rasterelement abgelenkte Teillichtbüschel in Richtung des korrespondierenden zweiten Rasterelementes abgelenkt wird, so dass ein Lichtweg zwischen ersten und zweiten Rasterelement ausgebildet wird.

10. Beleuchtungssystem gemäß einem der Ansprüche 1 bis 9, **dadurch gekennzeichnet, dass** die Bilder der Rasterelemente unscharf in die Retikelebene abgebildet werden.

11. Beleuchtungssystem nach einem der Ansprüche 8 bis 10, **dadurch gekennzeichnet, dass** die ersten Rasterelemente (5) auf dem ersten Spiegel oder der ersten Linse derart angeordnet sind, dass sie sich nicht überschneiden.

12. Beleuchtungssystem nach einem der Ansprüche 8 bis 11, **dadurch gekennzeichnet, dass** die zweiten Rasterelemente (9) auf dem zweiten Spiegel oder der Linse derart angeordnet sind, dass die Bilder der sekundären Lichtquellen eine Austrittspupille des Beleuchtungssystems mit einem vorbestimmten Muster ausleuchten.

13. Beleuchtungssystem nach einem der Ansprüche 8 bis 12, **dadurch gekennzeichnet, dass** durch Verkippung von erstem und zweiten Rasterelement zueinander, der Lichtweg zwischen einem ersten Rasterelement und einem korrespondierenden zweiten Rasterelement aufgebaut wird.

14. Beleuchtungssystem nach einem der Ansprüche 1 bis 9 oder 11 bis 13, **dadurch gekennzeichnet, dass** die ersten Rasterelemente in die Retikelebene abgebildet werden, wobei die Bilder der ersten Rasterelemente sich weitgehend überdecken.

15. Beleuchtungssystem nach einem der Ansprüche 8 bis 9 oder 11 bis 13, **dadurch gekennzeichnet, dass** die zweiten Rasterelemente die von den ersten Rasterelementen einfallenden Teilstrahlbüschel mit zweiten Ablenkwinkel ablenkt, so dass die Bilder der ersten Rasterelemente, die in die Retikelebene abgebildet werden sich weitgehend überdecken.

16. Beleuchtungssystem für Wellenlängen ≤ 193 nm, insbesondere für die EUV-Lithographie, **dadurch gekennzeichnet, dass** das Beleuchtungssystem wenigstens eine erste Lichtquelle und eine zweite Lichtquelle, die Strahlung mit einer Wellenlänge ≤ 193 nm emittiert umfasst.

17. Beleuchtungssystem nach Anspruch 16, **dadurch gekennzeichnet, dass** das Beleuchtungssystem ein optisches Element (100) umfasst und dass die erste Lichtquelle einen ersten Bereich (A1) und die zweite Lichtquelle einen zweiten Bereich (A2) des optischen Elementes (199) ausleuchtet.

18. Beleuchtungssystem nach einem der Ansprüche 16 bis 17, **dadurch gekennzeichnet, dass** das optische Element (100) ein erster Spiegel oder eine erste Linse mit ersten Rasterelementen ist.

19. Beleuchtungssystem für Wellenlängen ≤ 193 nm, insbesondere für die EUV-Lithographie, mit wenigstens einer Lichtquelle (1) wenigstens einem ersten Spiegel oder einer ersten Linse, die in Rasterelemente (5) gegliedert ist, **dadurch gekennzeichnet, dass** die ersten Rasterelemente eine Form aufweisen, wobei die Form der ersten Rasterelemente im wesentlichen die Form des ausgeleuchteten Feldes in der Retikelebene bestimmt.

20. Beleuchtungssystem gemäß Anspruch 19, **dadurch gekennzeichnet, dass** die Form des Feldes in der Retikelebene im wesentlichen die eines Ringfeldes ist.

21. Beleuchtungssystem gemäß Anspruch 19 oder 20, **dadurch gekennzeichnet, dass** die Form der ersten Rasterelemente im wesentlichen rechteckig ist.

22. Beleuchtungssystem gemäß einem der Ansprüche 19 bis 21, **dadurch gekennzeichnet, dass** das Beleuchtungssystem des weiteren einen zweiten Spiegel oder eine zweite Linse umfasst, die in zweite Rasterelemente (9) gegliedert ist.

23. Beleuchtungssystem gemäß einem der Ansprüche 19 bis 22, **dadurch gekennzeichnet, dass** das Beleuchtungssystem wenigstens einen Feldspiegel umfasst, der das Ringfeld in der Retikelebene formt.

24. Beleuchtungssystem gemäß Anspruch 23, **dadurch gekennzeichnet, dass** die ersten Rasterelemente durch die zweiten Rasterelemente und den wenigstens einen Feldspiegel in die Retikelebene abgebildet werden, und dass sich die Bilder der ersten Rasterelemente in der Retikelebene im wesentlichen überdecken.

25. Beleuchtungssystem nach einem der Ansprüche 20 bis 24, **dadurch gekennzeichnet, dass** die ersten Rasterelemente die im wesentlichen rechteckige Form aufweisen ein Aspektverhältnis aufweisen.

26. Beleuchtungssystem nach Anspruch 25, **dadurch gekennzeichnet, dass** das Aspektverhältnis zwischen 1:1 und 1:20 liegt.

27. Beleuchtungssystem nach mindestens einem der Ansprüche 23 bis 26, **dadurch gekennzeichnet, dass** der wenigstens eine Feldspiegel Toroidform aufweist, wobei die Querschnitte auch konische und asphärische Anteile haben können.

28. Projektionsbelichtungsanlage für die Mirkolithographie mit

- Wellenlängen ≤ 193 nm
- mit einem Beleuchtungssystem nach mindestens einem der Ansprüche 1 bis 27
- einer Maske auf einem Trägersystem
- einem Projektionsobjektiv
- einem lichtempfindlichen Objekt auf einem Trägersystem.

29. Projektionsbelichtungsanlage nach Anspruch 28, ausgeführt als Scanning-System.

30. Projektionsbelichtungsanlage nach mindestens einem der Ansprüche 28 bis 29, **dadurch gekennzeichnet, dass** die Beleuchtungsstärke am lichtempfindlichen Objekt - bei strukturloser Maske - weniger als ± 5 %, vorzugsweise weniger als ± 2 % ortsabhängige Unterschiede aufweist.

31. Projektionsbelichtungsanlage nach einem der Ansprüche 28 bis 30, **dadurch gekennzeichnet, dass** die Scan-Energie am lichtempfindlichen Objekt - bei strukturloser Maske - weniger als ± 5 %, vorzugsweise weniger als ± 2 %, ortsunabhängige Unterschiede aufweist.

32. Projektionsbelichtungsanlage nach einem der Ansprüche 28 bis 31, **dadurch gekennzeichnet, dass** die Projektionsbelichtungsanlage eine EUV-Projektionsbelichtungsanlage ist, die ein für EUV transparentes Vakuumfenster das im Strahlengang von der Lichtquelle zur Retikelebene angeordnet ist, umfasst.

33. Projektionsbelichtungsanlage nach Anspruch 32, **dadurch gekennzeichnet, dass** ein Vakuumfenster an einer Einschnürung des Lichtbündels im Beleuchtungssystem angeordnet ist.

34. Projektionsbelichtungsanlage für die Mirkolithographie mit Wellenlängen ≤ 193 nm, mit
einer Lichtquelle
einem Beleuchtungssystem das umfasst:

- eine Retikelebene
- eine Spiegel- oder Linsenvorrichtung mit einer Vielzahl von ersten Rasterelementen, die Licht von der Lichtquelle aufnehmen und
- wenigstens einem Feldspiegel der Licht von der Vielzahl von ersten Rasterelementen aufnimmt und ein Ringfeld formt
- einem Projektionsobjektiv

**dadurch gekennzeichnet, dass** die Hauptstrahlen divergent in das Projektionsobjektiv laufen.

**35.** Projektionsbelichtungsanlage nach Anspruch 34, **dadurch gekennzeichnet, dass** in der Retikelebene eine Maske angeordnet ist.

**36.** Verfahren zur Herstellung von mikroelektronischen Bauelementen, insbesondere Halbleiterchips mit einer Projektionsbelichtungsanlage gemäß einem der Ansprüche 28 bis 35.

## FIG. 1

## FIG. 2A

## FIG. 2B

_FIG.3_

y Feld
14
20
y Wabe
x Feld
x Wabe
22

_FIG.4_

20
32
14
30
22

_FIG.5_

20
32
22
30

_FIG.6_

sek. LQ
5
$Du._{gl}$
$NA_{RET}$
7
$R_{Pup}$
$d_1$
$d_2$
L

_FIG.7_ 100

A

102

_FIG.8_ A

102

_FIG.9_

A

100

_FIG. 10_

102

100

_FIG. 11_

A1    A2

A3    100    A4    102

_FIG. 12_

A1    A2    100

A3    102    A4

## FIG. 13

## FIG. 14

## FIG. 15

## FIG. 16

_FIG. 17_

_FIG. 18_

$Du_{Feld}$

$Du_{Pupille}$

$NA_{Ret}$

_FIG. 19_

$Du_{Feld}$ $Du_{Pupille}$

$NA_{Ret}$

*FIG. 20*

*FIG. 21*

*FIG. 22*

## FIG. 23

200

202

204

206

208

200.00 MM

## FIG. 24

202

200

204

206

208

150.00 MM

## FIG. 25

## FIG. 26

## FIG. 27

## FIG. 28

EP 1 434 240 A1

Intens. [%]

*FIG. 29*

Y in der Retikelebene [mm]

Scanenergie [%]

*FIG. 30*

X in der Retikelebene [mm]

31

_FIG. 31_

_FIG. 32_

## FIG. 33

300

302

## FIG. 34

300

302

306

304

## FIG. 35

310

302    306    304

300

## FIG. 36

310

300    302    306    304

## FIG. 37

## FIG. 38

## FIG. 39

## FIG. 40

## FIG. 41

*FIG. 42*

100.00MM

250.00 MM

*FIG. 43*

# FIG. 44

300

323

316

314

138.89MM

# FIG.45

300

323

314

227.27MM

## FIG.46

## FIG.47

## _FIG._ 48

EP 1 434 240 A1

## FIG.48A

## FIG.48B

## FIG.48C

40

*FIG. 49*

*FIG. 50*

*FIG. 51*

*FIG. 52*

## FIG.53

410

400

402

200.00 MM

## FIG.54

406

410

404

400

402

200.00 MM

## FIG.55

406

412

402

200.00 MM

400

FIG.56

414

418

420

416

406

400 402

412

268.82 MM

416

4

227.27 MM

FIG.57

402

422

400

## FIG. 58

424

416

4

250.00MM

410

400

402

422

## FIG.59

y [mm]

20
15
10
5
0
-5
-10
-15
-20

-80    -60    -40    -20    0    20    40    60    80

x [mm]

Scanenergie [%]

_FIG.60_

X in der Retikelebene [mm]

_FIG. 61_

Intensität [%]

FIG. 62

FIG. 63A

FIG. 63B

FIG. 64

**Europäisches Patentamt**

**EUROPÄISCHER RECHERCHENBERICHT**

Nummer der Anmeldung

EP 04 00 3479

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A,D | US 5 339 346 A (WHITE DONALD L) 16. August 1994 (1994-08-16) * Ansprüche 1-17 * ----- | 1 | G21K1/06 |
| A | US 5 439 781 A (WHITE DONALD L ET AL) 8. August 1995 (1995-08-08) * Ansprüche 1-17 * ----- | 1 | |
| A,D | US 5 737 137 A (COHEN SIMON J ET AL) 7. April 1998 (1998-04-07) * Ansprüche 1-11 * ----- | 1,16 | |
| A,D | US 5 361 292 A (SWEATT WILLIAM C) 1. November 1994 (1994-11-01) * Ansprüche 1-18 * ----- | 1 | |
| A,D | US 5 581 605 A (MURAKAMI KATSUHIKO ET AL) 3. Dezember 1996 (1996-12-03) * Ansprüche 1,14 * ----- | 1,16 | |
| A | US 4 651 012 A (CLARK BENTON C ET AL) 17. März 1987 (1987-03-17) * Ansprüche 1-27 * ----- | 1 | RECHERCHIERTE SACHGEBIETE (Int.Cl.7) G21K |
| A | US 5 669 708 A (TANITSU OSAMU ET AL) 23. September 1997 (1997-09-23) * Ansprüche 1,4,11,14 * ----- | 1 | |
| A | EP 0 359 018 A (SIEMENS AG) 21. März 1990 (1990-03-21) ----- | | |
| Y | EP 0 779 558 A (NIPPON KOGAKU KK) 18. Juni 1997 (1997-06-18) * Ansprüche 1-8 * ----- | 16 | |
| Y | US 5 499 282 A (SILFVAST WILLIAM T) 12. März 1996 (1996-03-12) * Ansprüche 1,2,10 * ----- | 16 | |

Der vorliegende Recherchenbericht wurde für alle Patentansprüche erstellt

| Recherchenort | Abschlußdatum der Recherche | Prüfer |
|---|---|---|
| Den Haag | 19. April 2004 | Van den Bulcke, E |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
...........................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.** EP 04 00 3479

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-04-2004

| Im Recherchenbericht angeführtes Patentdokument | | Datum der Veröffentlichung | Mitglied(er) der Patentfamilie | | Datum der Veröffentlichung |
|---|---|---|---|---|---|
| US 5339346 | A | 16-08-1994 | CA | 2121819 A1 | 21-11-1994 |
| | | | DE | 69421447 D1 | 09-12-1999 |
| | | | DE | 69421447 T2 | 06-07-2000 |
| | | | EP | 0626621 A1 | 30-11-1994 |
| | | | HK | 1005836 A1 | 28-04-2000 |
| | | | JP | 3291393 B2 | 10-06-2002 |
| | | | JP | 7169677 A | 04-07-1995 |
| US 5439781 | A | 08-08-1995 | CA | 2121608 A1 | 11-11-1994 |
| | | | EP | 0627667 A1 | 07-12-1994 |
| | | | JP | 3429361 B2 | 22-07-2003 |
| | | | JP | 6333798 A | 02-12-1994 |
| US 5737137 | A | 07-04-1998 | KEINE | | |
| US 5361292 | A | 01-11-1994 | KEINE | | |
| US 5581605 | A | 03-12-1996 | JP | 3316699 B2 | 19-08-2002 |
| | | | JP | 6235797 A | 23-08-1994 |
| | | | JP | 3144175 B2 | 12-03-2001 |
| | | | JP | 7084108 A | 31-03-1995 |
| | | | JP | 7094397 A | 07-04-1995 |
| | | | JP | 7249561 A | 26-09-1995 |
| | | | US | 5669708 A | 23-09-1997 |
| US 4651012 | A | 17-03-1987 | KEINE | | |
| US 5669708 | A | 23-09-1997 | JP | 3316699 B2 | 19-08-2002 |
| | | | JP | 6235797 A | 23-08-1994 |
| | | | JP | 3144175 B2 | 12-03-2001 |
| | | | JP | 7084108 A | 31-03-1995 |
| | | | JP | 7094397 A | 07-04-1995 |
| | | | JP | 7249561 A | 26-09-1995 |
| | | | US | 5581605 A | 03-12-1996 |
| EP 0359018 | A | 21-03-1990 | EP | 0359018 A2 | 21-03-1990 |
| | | | JP | 2121251 A | 09-05-1990 |
| | | | US | 4996441 A | 26-02-1991 |
| EP 0779558 | A | 18-06-1997 | JP | 9162110 A | 20-06-1997 |
| | | | EP | 0779558 A2 | 18-06-1997 |
| | | | US | 5880817 A | 09-03-1999 |
| US 5499282 | A | 12-03-1996 | KEINE | | |

EPO FORM P0461

Für nähere Einzelheiten zu diesem Anhang : siehe Amtsblatt des Europäischen Patentamts, Nr.12/82